(19) Europäisches Patentamt
European Patent Office
Office européen des brevets

(11) EP 2 058 845 A1

(12) **EUROPEAN PATENT APPLICATION**
published in accordance with Art. 153(4) EPC

(43) Date of publication:
**13.05.2009 Bulletin 2009/20**

(21) Application number: **07792889.3**

(22) Date of filing: **22.08.2007**

(51) Int Cl.:
***H01L 21/205*** *(2006.01)* ***C23C 16/455*** *(2006.01)*
***C23C 16/509*** *(2006.01)*

(86) International application number:
**PCT/JP2007/066303**

(87) International publication number:
**WO 2008/026491 (06.03.2008 Gazette 2008/10)**

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK RS**

(30) Priority: **28.08.2006 JP 2006231134**

(71) Applicant: **Mitsubishi Heavy Industries, Ltd.**
**Tokyo 108-8215 (JP)**

(72) Inventors:
- **KAWANO, Shingo**
  **Nagasaki-shi, Nagasaki 851-0392 (JP)**
- **OHTSUBO, Eiichiro**
  **Nagasaki-shi, Nagasaki 850-8610 (JP)**
- **MIYAZONO, Naoyuki**
  **Nagasaki-shi, Nagasaki 850-8610 (JP)**
- **KAWAMURA, Keisuke**
  **Nagasaki-shi, Nagasaki 851-0392 (JP)**
- **TAKEUCHI, Yoshiaki**
  **Nagasaki-shi, Nagasaki 851-0392 (JP)**

(74) Representative: **Bongiovanni, Simone et al**
**STUDIO TORTA**
**Via Viotti 9**
**10121 Torino (IT)**

# (54) THIN FILM MANUFACTURING APPARATUS USING DISCHARGE ELECTRODE, AND SOLAR CELL MANUFACTURING METHOD

(57) A discharge electrode, a thin-film deposition apparatus, and a solar cell fabrication method, which suppress the generation of a film thickness distribution and a film quality distribution, are provided. The discharge electrode includes two lateral structures 20 that are substantially parallel to each other and extend in an X direction; and a plurality of longitudinal structures 21a that are provided between the two lateral structures, are substantially parallel to each other, and extend in a Y direction substantially orthogonal to the X direction. The longitudinal structures 21a each include an electrode main body 35 whose one end 35a is connected to one of the lateral structures 20 and whose the other end 35b is connected to the other lateral structure 20; a gas pipe 41 disposed in a gas-pipe accommodating space 36; and a porous body 40. An opening 38 opens to a substrate 8 and is covered with the porous body 40. A gas diffusion path 37 connects the gas-pipe accommodating space 36 and the opening 38. The electrode inner surface 39 faces the gas-pipe accommodating space 36 and opposes the pipe outer surface 42b. A nozzle hole group 42c is arranged in the second direction in the gas pipe 41, and faces a section 39a at a side opposite to the gas diffusion path 37 in the electrode inner surface 39.

FIG. 7A

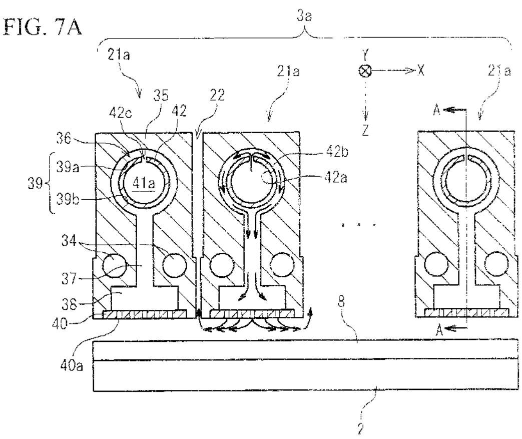


EP 2 058 845 A1

## Description

Technical Field

The present invention relates to a discharge electrode used for plasma generation, a thin-film deposition apparatus using the same, and a solar cell fabrication method.

Background Art

With thin-film depositing apparatuses for depositing thin films for amorphous silicon solar cells, microcrystalline silicon solar cells, and thin film transistors (TFTs), the area of the substrate has been increased from the viewpoint of improving fabrication efficiency. When depositing a film on such a large area substrate (for example, larger or equal to 1 m $\times$ 1 m), it is efficient to employ a method using high-frequency plasma. When using high-frequency plasma, it is effective to use a film deposition method employing a ladder-type electrode, instead of using a film deposition apparatus with a simple parallel-plate-type electrode. As such as film deposition method according to the related art, a known technique using a ladder electrode is disclosed in Japanese Unexamined Patent Application, Publication No. 2002-322563.

To reduce costs of a tandem solar cell including a microcrystalline layer, high-speed deposition is required since the film thickness of the microcrystalline i layer, which is the power generating layer, is several $\mu$m and is five to ten times greater than the film thickness of the amorphous silicon i layer. To form a high-quality power generating layer at high speed, it is necessary to employ a high-pressure narrow-gap method, described in Japanese Unexamined Patent Application, Publication No. 2005-150317, in which the gap distance between the substrate and the electrode is reduced and the deposition pressure is increased. Fig. 1 is a diagram illustrating the relationship between a cross-section of an electrode according to a case in which a high-pressure narrow-gap method according to the related art is employed and the deposition speed distribution in local areas corresponding to the shape change in an electrode. The upper half of the drawing is a sectional view of the structure associated with film deposition, and the bottom half illustrates the relationship between the structure and the film thickness. The vertical axis represents film thickness, and the horizontal axis represents positions on the substrate. A ladder discharge electrode 103 of the film deposition apparatus includes a plurality of cylindrical electrodes 121a. The plurality of electrodes 121a faces the substrate 108 on the counter electrode (not shown). Deposition gas flows through a gas flow path 131 inside the electrodes 121a, and part of the gas is ejected from a plurality of gas ejection holes 137. Plasma is generated by electrical power applied between the discharge electrode 103 and the counter electrode, and deposition gas is decomposed and combined to deposit a film on the substrate 108. However, in the high-pressure narrow-gap method, a film thickness distribution is caused by local structures of the discharge electrode 103. In other words, as shown in the drawing, the thickness in areas close to the electrodes 121a is large, and the thickness in areas far away is small. Such a distribution in film thickness causes a distribution in battery performance.

Fig. 2 is diagram illustrating the relationship between a cross-section of an electrode and the deposition speed distribution according to a case in which a high-pressure narrow-gap method according to the related art is employed. The gap distance between the substrate and the electrode is, for example, 5 mm. In such a case, the structure of the electrodes 121b differs from the electrodes 121a in Fig. 1. In other words, the electrodes 121b are rectangular rods. Deposition gas flows through gas flow paths 131 inside the electrode 121b, and part of the gas is ejected from a plurality of grooves 137 through gas ejection holes 132 and gas diffusion paths 134. At this time the surfaces of the electrodes 121b on the substrate 108 side are flat surfaces parallel to the surface of the substrate 108.
Fig. 3 is a graph illustrating the distribution of the deposition speed at local areas corresponding to the electrode shape change when film deposition is carried out using the electrode shown in Fig. 2. The vertical axis represents the deposition speed, where a deposition speed of 2.5 nm/s is normalized to 1.0. The horizontal axis represents measurement position numbers on the substrate, indicating measurement points at equal intervals. The substrate position corresponding to the gas ejection hole 132 that was used as a reference in the evaluated discharge electrode 103 is defined as measurement point number 0. A1, A2, and A3 in the graph correspond to positions A1, A2, and A3 in Fig. 2. When the deposition speeds (which have almost the same tendency as the film thickness) at the positions A1, A2, and A3 are compared, the deposition speed is lower at the position A3 in the case of high deposition pressure (for example, 950 Pa or 1300 Pa) than that in the case of low deposition pressure (for example, 650 Pa), and the deposition speed distribution (= film thickness distribution) becomes great. In addition, although not shown in the drawings, there is a distribution of film quality, for example, the intensity ratio of Raman scattering I (520 $cm^{-1}$)/I (480 $cm^{-1}$) in the case of microcrystalline silicon. In other words, in an area, at the position A1, where the raw gas concentration (in particular, $SiH_4$ gas concentration) is high, the intensity ratio is small and the film is amorphous, whereas, when the raw gas concentration at the positions A2 and A3 changes from the value at the position A1, the intensity ratio is large and the film is microcrystalline. In this way, the distributions of film thickness and film quality cause a distribution in the battery performance.

As described above, to use the high-pressure narrow-gap method, a technology for appropriately adjusting the local structure of the discharge electrode is desired. As the local structure of a ladder discharge electrode to be used for the high-pressure narrow-gap method, a technology that takes into consideration the flow of the deposition gas and the plasma distribution, and suppresses the generation of a film quality distribution and a film thickness distribution is desired.

Disclosure of Invention

An object of the present invention is to provide a discharge electrode, a thin-film deposition apparatus using the same, and a solar cell fabrication method, which suppress the generation of a film thickness distribution and a film quality distribution even when film deposition is carried out with a small distance between a substrate and an electrode and a high deposition pressure in order to improve the film quality distribution and to increase the deposition speed.

Another object of the present invention is to provide a discharge electrode, a thin-film deposition apparatus using the same, and a solar cell fabrication method that allow easy maintenance of nozzles from where gas is ejected.

The discharge electrode according to the present invention includes two lateral structures that are substantially parallel to each other and extend in a first direction (X direction); and a plurality of longitudinal structures that are provided between the two lateral structures, are substantially parallel to each other, and extend in a second direction (Y direction) substantially orthogonal to the first direction. The plurality of longitudinal structures each include an electrode main body whose first end is connected to one of the lateral structures and whose second end, which is the end opposite to the first end, is connected to the other lateral structure, a gas pipe disposed in a gas-pipe accommodating space provided inside the electrode main body, and a porous body. The electrode main body includes a first opening open at a counter electrode holding a substrate and a gas diffusion path provided between the gas-pipe accommodating space and the first opening to connect the gas-pipe accommodating space and the first opening. The first opening is covered by the porous body. The gas pipe has a nozzle hole group that penetrates from a pipe inner surface to a pipe outer surface of the gas pipe. The gas pipe, the gas-pipe accommodating space, the gas diffusion path, and the first opening extend in the second direction. The electrode main body has an electrode inner surface that faces the gas-pipe accommodating space and opposes the pipe outer surface. The nozzle hole group is arranged in the second direction in the gas pipe.
With the discharge electrode according to the present invention, maintainability of the discharge electrode is improved by the structure in which a gas pipe is provided inside the electrode main body.

With the discharge electrode according to the present invention, it is preferable that the nozzle hole group face the electrode inner surface, and it is particularly preferable that the nozzle hole group face a section of the electrode inner surface opposite to the gas diffusion path. Here, the gas ejected from the nozzle hole group passes through the gap between the pipe outer surface and the electrode inner surface, the gas diffusion path, the first opening, and the porous body, in this order, and is ejected toward the substrate from the gas ejection holes provided in the porous body.
With the discharge electrode according to the present invention, the nozzle hole group provided in the gas pipe faces the electrode inner surface and does not face the gas diffusion path. Therefore, the gas ejected from the nozzle hole group moves a long distance before reaching the gas diffusion path, and the movement direction of the gas changes while the gas is moving. As a result, diffusion of the gas in the first and second directions is promoted in the gap between the pipe outer surface and the electrode inner surface. Moreover, by providing gas ejection holes on the entire surface of the porous body, the distribution of gas in the second direction becomes more uniform, and the distribution of gas in the first direction also becomes more uniform. Therefore, the gas distribution in the first and second directions on the substrate becomes uniform.

With the discharge electrode according to the present invention, it is preferable that a ratio S2/S1 of a flow path sectional area S1 of the gas pipe to a total ejection area S2 of the nozzle hole group provided on each gas pipe be greater than 0 and smaller than 1/5.
When the ratio S2/S1 satisfies this condition, the pressure distribution of gas in the gas pipe becomes uniform, and gas is ejected in a uniform manner from the nozzle hole group.

With the discharge electrode according to the present invention, it is preferable that the nozzle hole group be arranged in the second direction at a nozzle pitch L. Here, a gap distance w between the pipe outer surface and the electrode inner surface and an ejection area S of one nozzle hole of the nozzle hole group satisfy $0 < S/(2wL) < 1$.
According to the present invention, the flow-path sectional area (2wL), corresponding to one nozzle hole of the nozzle hole group, of the gap between the pipe outer surface and the electrode inner surface is larger than the ejection area S of one nozzle hole. In such a case, the flow speed of the gas ejected from the nozzle hole becomes smaller than the ejection speed at the nozzle hole while the gas moves through the gap between the pipe outer surface and the electrode inner surface to the gas diffusion path, and the gas is sufficiently diffused in the first direction before reaching the porous body.

It is preferable that the discharge electrode according to the present invention include a spacer disposed between the electrode inner surface and the pipe outer surface. The space appropriately maintains the gap distance w between the electrode inner surface and the pipe outer surface.

With the discharge electrode according to the present invention, the gas-pipe accommodating space has a first center axis, and the gas pipe has a second center axis. Here, it is preferable that the spacer be provided on the pipe outer surface such that the spacer contacts the electrode inner surface before misalignment of the first center axis and the second center axis with respect to a direction orthogonal to the first center axis exceeds 25% of a gap distance w1 between the pipe outer surface and the electrode inner surface when the first center axis and the second center axis are aligned. The spacer may be provided on the electrode inner surface in contact with the pipe outer surface. With the discharge electrode according to the present invention, it is preferable that the material of the gas pipe and the electrode main body be an aluminum material. An aluminum material is preferable in view of resistance against the plasma and resistance against fluorine when performing self-cleaning. Since the gas pipe and the electrode main body are composed of the same material, the gap between the pipe outer surface and the electrode inner surface is prevented from being reduced due to thermal expansion.

With the discharge electrode according to the present invention, it is preferable that the material of the electrode main body be an aluminum material, and the material of the gas pipe be non-magnetic stainless steel. By using non-magnetic stainless steel as the material of the gas pipe, costs can be reduced. Stainless steel is selected by non-magnetic taking into consideration the corrosion resistance against the plasma and fluorine when performing self-cleaning. The linear expansion coefficients of stainless steel (for example, SUS304) and the aluminum material are similar. Therefore, the gap between the pipe outer surface and the electrode inner surface is prevented from being reduced due to thermal expansion.

With the discharge electrode according to the present invention, it is preferable that said one of the lateral structures include a header extending in the first direction. In such a case, the gas pipe includes a pipe end section protruding from the gas-pipe accommodating space at the first end. The header includes a depression and a gas flow path communicating with the depression. The header is attached to the first end in a removable manner such that the pipe end section is inserted into the depression. The gas pipe communicates with the gas flow path through the pipe end section and the depression. With the present invention, since the header is removable, the gas pipe can be removed from the gas-pipe accommodating space. Therefore, maintenance of the nozzle hole group 42 can be easily carried out. With the present invention, since the gas pipe is removed in its axial direction (in the direction of the center axis S41), the section that requires sealing becomes small.

With the discharge electrode according to the present invention, it is preferable that the depression have a bottom surface and a sidewall having an annular groove. In such a case, an O-ring for sealing the gap between the depression and the pipe end section is disposed in the annular groove. It is preferable that the distance (L1) between the bottom surface and the annular groove in the direction in which the pipe end section is inserted into the depression be approximately 10 mm. However, the distance may be larger or smaller than 10 mm. When a film is deposited on a substrate having a side of 1 m or larger, a gas pipe having a length of 1 m or longer is used. To correspond to such a long gas pipe, it is preferable to set the distance L1 to approximately 10 mm. However, the distance may be larger or smaller than 10 mm. In this way, even when the gas pipe expands or contracts by $\pm 5$ mm, deformation of the gas pipe and leakage of gas from the sealed section can be prevented.

With the discharge electrode according to the present invention, it is preferable that a key be provided on the pipe end section, and a key groove that engages with the key be provided in the depression. Because of the key structure, it is easy to align the nozzle hole group when, for example, reassembling after maintenance. With the discharge electrode according to the present invention, it is preferable that the spacer be provided on the gas-pipe outer surface, a key be provided on the electrode inner surface, and a key groove that engages with the key be provided on the spacer. In this case, the key structure also makes it easy to align the nozzle hole group when, for example, reassembling after maintenance.

With the discharge electrode according to the present invention, it is preferable that an eye mark indicating the position of the nozzle hole group be provided on the pipe end section. The nozzle hole group can be aligned according to the eye mark when, for example, reassembling after maintenance. With the discharge electrode according to the present invention, it is preferable that the gas pipe be a rectangular pipe. By using a gas pipe that is not circular, it is easy to align the nozzle hole group when, for example, reassembling after maintenance.

With the discharge electrode according to the present invention, it is preferable that the electrode main body include a first section and a second section that is attached to the first section in a removable manner such that the first section and the second section sandwich the inner space. The first section includes the first opening, the gas diffusion path, and a section of the electrode inner surface on the side of the gas diffusion path. The second section includes a section of the electrode inner surface on the side opposite to the gas diffusion path. According to the present invention, since the first section and the second section are removable, the gas pipe can be removed from the gas-pipe accommodating space. Therefore, maintenance of the nozzle hole group can be easily carried out.

The discharge electrode according to the present invention includes two lateral structures that are substantially parallel to each other and extend in a first direction (X direction); and a plurality of longitudinal structures that are provided between the two lateral structures, are substantially parallel to each other, and extend in a second direction (Y direction) substantially orthogonal to the first direction. The plurality of longitudinal structures each include an electrode main body having one end connected to one of the lateral structures and the other end connected to the other lateral structure, the electrode main body extending in the second direction; a gas block having one end connected to said one of the lateral structures and the other end connected to the other lateral structure, the gas block extending in the second direction; and a porous body. The electrode main body includes a first opening open at a counter electrode holding a substrate; a first attachment section disposed on a side opposite to the first opening; a gas diffusion path provided between the first opening and the first attachment section and communicating with the first opening; and a second opening where the gas diffusion path opens at the first attachment section. The first opening, the first attachment section, the gas diffusion path, and the second opening extend in the second direction. The first opening is covered by the porous body. The gas block includes a gas flow path provided inside the gas block, a second attachment section, and a nozzle hole group which is provided between the gas flow path and the second attachment section to communicate with the gas flow path and opens at the second attachment section. The gas flow path and the second attachment section extend in the second direction. The nozzle hole group is arranged on the gas block in the second direction. The gas block is attached to the electrode main body in a removable manner such that the first attachment section and the second attachment section engage and such that the nozzle hole group communicates with the gas diffusion path.
Here, the gas ejected from the gas flow path through the nozzle hole group into the gas diffusion path is passed through the first opening and the porous body, in this order, and then is ejected toward the substrate from the gas ejection holes provided on the porous body. According to the present invention, gas is uniformly ejected from the porous by providing gas ejection holes on the entire surface of the porous body. Therefore, the gas distribution on the substrate is made uniform. According to the present invention, since the gas block and the electrode main body are removable, maintenance of the nozzle hole group can be easily carried out.

A thin-film deposition apparatus according to the present invention includes a film deposition chamber; a discharge electrode disposed inside the film deposition chamber; and a counter electrode opposing the discharge electrode and being disposed inside the film deposition chamber.

The solar cell fabrication method according to the present invention is a solar cell fabrication method using a thin-film deposition apparatus. The thin-film deposition apparatus includes a film deposition chamber; a discharge electrode disposed inside the film deposition chamber; and a counter electrode opposing the discharge electrode and being disposed inside the film deposition chamber. The solar cell fabrication method includes the steps of (a) supporting a substrate by the counter electrode; (b) introducing deposition gas to the film deposition chamber through the gas pipe, the nozzle hole group, the gas diffusion path, and the porous body; and (c) depositing a thin film for the solar cell by applying electrical power between the discharge electrode and the counter electrode while introducing the gas.

The present invention provides a discharge electrode, a thin-film deposition apparatus using the same, and a solar cell fabrication method that are capable of suppressing the generation of a film thickness distribution and a film quality distribution even when film deposition is carried out with the distance between a substrate and an electrode being small and the deposition pressure being high in order to improve the film quality distribution and increase the deposition speed.

Brief Description of Drawings

[FIG. 1] Fig. 1 is diagram illustrating the relationship between a cross-section of an electrode and the distribution of deposition speed when employing a high-pressure narrow-gap method according to the related art.

[Fig. 2] Fig. 2 is diagram illustrating the relationship between a cross-section of an electrode and the distribution of deposition speed when employing a high-pressure narrow-gap method according to the related art.

[Fig. 3] Fig. 3 is graph illustrating the distribution of the deposition speed when film deposition is carried out using the electrode shown in Fig. 2.

[Fig. 4] Fig. 4 is a side sectional view illustrating the configuration, in outline, of the thin-film deposition apparatus according to an embodiment of the present invention.

[Fig. 5] Fig. 5 is a partial perspective view of part of the configuration of the thin-film deposition apparatus according to an embodiment of the present invention.

[Fig. 6] Fig. 6 is a schematic block diagram illustrating the configuration associated with high-frequency electrical power supply in the thin-film deposition apparatus according to an embodiment of the present invention.

[Fig. 7A] Fig. 7A is a lateral sectional view of the discharge electrode according to a first embodiment of the present invention.

[Fig. 7B] Fig. 7B is a longitudinal sectional view of the discharge electrode according to the first embodiment of the present invention.

[Fig. 7C] Fig. 7C is a partial front view of the discharge electrode according to the first embodiment of the present invention.

[Fig. 8] Fig. 8 is a transparent view of the surroundings of a gas pipe of the discharge electrode according to the first embodiment of the present invention.

[Fig. 9] Fig. 9 is a graph illustrating the relationship between the sectional area ratio and the flow rate distribution of the discharge electrode according to the first embodiment of the present invention.

[Fig. 10A] Fig. 10A is a transparent view of an example spacer for maintaining a constant gap distance between the gas pipe and the electrode in the discharge electrode according to the first embodiment of the present invention.

[Fig. 10B] Fig. 10B is a transparent view of another example spacer for maintaining a constant gap distance between the gas pipe and the electrode in the discharge electrode according to the first embodiment of the present invention.

[Fig. 11] Fig. 11 is graph of the relationship between the flow rate and the misalignment of the gas pipe and the center axis of the electrode distribution in the discharge electrode according to the first embodiment of the present invention.

[Fig. 12] Fig. 12 is a perspective view of a header of the discharge electrode according to the first embodiment of the present invention.

[Fig. 13] Fig. 13 is a sectional view illustrating the engagement of the pipe end of the gas pipe and the header.

[Fig. 14A] Fig. 14A is a perspective view illustrating a case in which key structures are provided on the gas pipe and the header so as to align the nozzle holes of the gas pipe.

[Fig. 14B] Fig. 14B is a perspective view illustrating a case in which key structures are provided on the gas pipe and the electrode main body so as to align the nozzle holes of the gas pipe.

[Fig. 15A] Fig. 15A is a sectional view of a modification of the discharge electrode according to the first embodiment of the present invention.

[Fig. 15B] Fig. 15B is a sectional view of another modification of the discharge electrode according to the first embodiment of the present invention.

[Fig. 15C] Fig. 15C is a sectional view of another modification of the discharge electrode according to the first embodiment of the present invention.

[Fig. 16] Fig. 16 is a sectional view of a discharge electrode according to a second embodiment of the present invention.

[Fig. 17] Fig. 17 is a sectional view of a discharge electrode according to a third embodiment of the present invention.

Best Mode for Carrying Out the Invention

A discharge electrode, a thin-film deposition apparatus, and a solar cell fabrication method according to the present invention will be described below with reference to the accompanying drawings.

[First Embodiment]

First, the configuration of a thin-film deposition apparatus according to a first embodiment of the present invention will be described. Fig. 4 is a side sectional view illustrating the configuration, in outline, of the thin-film deposition apparatus according to the first embodiment of the present invention. A thin-film deposition apparatus 1 includes a film deposition chamber 6, a counter electrode 2, a heat equalizer plate 5, a heat-equalizer-plate holding mechanism 11, a discharge electrode 3, an back plate 4, a supporting section 7, a radio-frequency power feeding path 12 (12a and 12b), matching boxes 13 (13a and 13b), a high-vacuum evacuating section 19, a low-vacuum evacuating section 17, and a table 18. In the drawings, components associated with gas supply are omitted.

The film deposition chamber 6 is a vacuum vessel, and a film is deposited therein on a substrate 8. The film deposition chamber 6 is supported on the table 18.

The counter electrode 2 is a metal plate having a holding section (not shown) for holding the substrate 8. The counter electrode 2 is an electrode (for example, the grounding side) opposing the discharge electrode 3 when depositing a film. The substrate is held such that one side of the counter electrode 2 closely contacts with the surface of the heat equalizer plate 5, and the other side closely contacts with the surface of the substrate 8 when depositing a film. By placing the substrate 8 in contact with the heat equalizer plate 5, heat can be easily transferred between the heat equalizer plate 5 and the substrate 8, and the temperature of the entire substrate 8 can be made uniform.

The heat equalizer plate 5 makes the temperature of the contacting counter electrode 2 uniform so as to maintain the temperature of the entire plate substantially uniform. The heat equalizer plate 5 is constructed of a non-magnetic material having good heat conductivity and, preferably, having corrosion resistance against fluorine when performing self-cleaning, e.g., aluminum alloy or Ni alloy such as inconel. When the surface of the counter electrode 2 contacts the surface of the heat equalizer plate 5, the heat equalizer plate 5 acts as a path of heat, and thus, the temperature distribution of the member can be spread out. The heat equalizer plate 5 is capable of controlling its own temperature by circulating a temperature-controlled heating medium therein or incorporating a temperature-controlled heater therein.

The heat-equalizer-plate holding mechanism 11 holds the heat equalizer plate 5 and the counter electrode 2 such that the heat equalizer plate and the counter electrode are substantially parallel to the side surface of the film deposition chamber 6. Then, when depositing a film, the heat-equalizer-plate holding mechanism 11 moves the heat equalizer plate 5, the counter electrode 2, and the substrate 8 closer to the discharge electrode 3.

The discharge electrode 3 is separated into a plurality of ladder-type electrodes. The discharge electrode 3 receives high-frequency electrical power from a feeding point 53 connected to the radio-frequency power feeding path 12a and a feeding point 54 connected to the radio-frequency power feeding path 12b. When depositing a film, the discharge electrode 3 becomes an electrode (for example, the high-frequency electrical power input side) opposing the counter electrode 2 (for example, the grounding side). A film is deposited on the substrate 8 by plasma generated by an electrical discharge between the discharge electrode 3 and the counter electrode 2.

The depostion preventing plate 4 is grounded, and restricts the area where a film is deposited by restricting the area where the plasma spreads out. In the case of Fig. 4, a film is prevented from being deposited on the wall behind the back plate 4 (opposite to the substrate 8) on the inner side of the film deposition chamber 6.

The supporting section 7 extends inward from the side surface of the film deposition chamber 6, perpendicularly with respect to the discharge electrode 3. The supporting section 7 is engaged with the back plate 4 to hold the back plate 4 so as to cover the space on a side of the discharge electrode 3 opposite to the counter electrode 2. At the same time, the supporting section 7 is connected to the discharge electrode 3 in an insulated manner and holds the discharge electrode 3 substantially parallel to the side surface of the film deposition chamber 6.

The matching boxes 13 (13a and 13b) are capable of matching the impedance at the outputs. High-frequency electrical power is supplied from a radio-frequency power supply, which is not shown, via a radio-frequency power feeding path 14 (14a and 14b). The high-frequency electrical power is supplied to the discharge electrode 3 via the radio-frequency power feeding path 12 (12a and 12b).

For example, a heating medium is supplied from a heating-medium supplying device (not shown) to the matching box 13b via a heating-medium supplying pipe 15b, and is supplied to the discharge electrode 3 via the radio-frequency power feeding path 12b and the feeding point 54. Subsequently, the heating medium is supplied from the discharge electrode 3 via the feeding point 53 and the radio-frequency power feeding path 12a and is sent to the heating-medium supplying device via a heating-medium supplying pipe 15a. The temperature of the heating medium is controlled by the heating-medium supplying device (for example, PID control based on the difference between the measured temperature and a set value), and thus, the temperature of the discharge electrode 3 can be maintained at a predetermined temperature. In this case, it is preferable to flow the heating medium from the matching box 13b on the lower side to the matching box 13a on the upper side. The heating medium can be spread throughout the discharge electrode 3, without generating sites where the heating medium is accumulated or does not reach.

The radio-frequency power feeding path 12 (12a and 12b) allows the heating medium to pass through, for example, a narrow pipe provided at the center area of the circular pipe of the radio-frequency power feeding path 12 and transfer electrical power through the circumferential section.

Instead, the configuration may be opposite of that described above. Furthermore, a pipe exclusively used for the heating medium may be provided. The radio-frequency power feeding path 12 is vacuum-sealed by an O-ring provided in the wall of the film deposition chamber 6. One end of the radio-frequency power feeding path 12 is electrically connected to the discharge electrode 3, and the other end is electrically connected to the matching boxes 13. The high-frequency electrical power from the matching boxes 13 is supplied to the discharge electrode 3.

The high-vacuum evacuating section 19 includes a high vacuum pump and an on-off valve for evacuating gas inside the film deposition chamber 6. The low-vacuum evacuating section 17 includes a roughin vacuum pump and an on-off valve for evacuating gas inside the film deposition chamber 6.

The table 18 holds the film deposition chamber 6. There is an area containing the low-vacuum evacuating section 17 inside the table 18. The table 18 holds the film deposition chamber 6 so as to be tilted at an angle $\theta$=7° to 12° with respect to the Z direction (vertical direction). More preferably, the angle is approximately 10°. In this way, the surface of the counter electrode 2 in contact with the substrate 8 is faced upward at an angle of 7° to 12° with respect to the z direction. It is preferable to slightly tilt the substrate 8 from the vertical direction because the substrate 8 can be easily supported with its own weight, and the installation area in the film deposition chamber 6 can thus be reduced.

Fig. 5 is a partial perspective view of part of the configuration of the thin-film deposition apparatus according to the first embodiment of the present invention. Directions are indicated by arrows in the drawing. The discharge electrode 3 includes ladder-type electrodes. In this embodiment, the discharge electrode 3 includes eight ladder-type electrodes, i.e., discharge electrodes 3a to 3h. However, the number of ladder-type electrodes is not limited thereto, and any number appropriate for supplying a uniform radio frequency to obtain uniform plasma in order to facilitate fabrication may be selected. Moreover, the discharge electrode 3 may be constructed of one ladder-type electrode. Each of the discharge electrodes 3a to 3h includes two lateral structures 20 extending in the X direction substantially parallel to each other and a plurality of longitudinal structures 21 being provided between the two lateral structures 20 and extending in the Y direction, which is substantially orthogonal to the X direction, substantially parallel to one another. The Z direction is substantially orthogonal to the X and Y directions.

For each of the discharge electrodes 3a to 3h, the matching box 13a, the radio-frequency power feeding path 14a, the radio-frequency power feeding path 12a, the heating-medium supplying pipe 15a, and a raw-gas pipe 16a are provided on the side of the feeding point 53, and the matching box 13b, the radio-frequency power feeding path 14b, the radio-frequency power feeding path 12b, the heating-medium supplying pipe 15b, and a raw-gas pipe 16b are provided on the side of the feeding point 54. The radio-frequency power feeding path 12 is vacuum-sealed by an O-ring provided in the wall of the film deposition chamber 6. In Fig. 5, only the matching box 13, the radio-frequency power feeding path 14, the radio-frequency power feeding path 12, the heating-medium supplying pipe 15, and the raw-gas pipe 16 that are associated with the discharge electrode 3a are illustrated.

Each of the discharge electrodes 3a to 3h is connected to the raw-gas pipe 16a near the feeding point 53. Raw gas is supplied from the raw-gas pipe 16a. Similarly, the raw-gas pipe 16b is connected near the feeding point 54. Raw gas is supplied from the raw-gas pipe 16b. Each of the discharge electrodes 3a to 3h ejects the supplied raw gas in the direction indicated by arrows in the drawing, i.e., toward the substrate 8, from the surfaces of the discharge electrodes. In the first embodiment, eight groups of the matching box 13a, the radio-frequency power feeding path 14a, the matching box 13b, and the radio-frequency power feeding path 14b are provided, and electrical power is supplied to the discharge electrodes 3a to 3h by these eight groups. However, the number of groups is not limited to eight. The number of feeding points may correspond to the number of discharge electrodes, or electrical power may be supplied by less than eight groups. In such a case, the discharge electrodes 3a to 3h are grouped to correspond to the number of groups to be used.

Fig. 6 is a schematic block diagram illustrating the configuration associated with high-frequency electrical power supply in the thin-film deposition apparatus according to the first embodiment of the present invention. The thin-film deposition apparatus 1 includes a power supply 60. The power supply 60 includes an RF amplifier (radio-frequency power supply A) 62, an RF amplifier (radio-frequency power supply B) 63, a radio-frequency (RF) oscillator 64, a radio-frequency (RF) oscillator 65, a selector switch 66, and a function generator 67.

The radio-frequency oscillator 64 generates, for example, a 60-MHz radio-frequency (RF) signal, and then sends the signal to the RF amplifier 62 and the selector switch 66. At this time, the radio-frequency oscillator 64 uses a built-in phase shifter to modulate the phase of the radio-frequency. The radio-frequency (RF) oscillator 65 generates, for example, a 58.5-MHz radio-frequency (RF) signal, and then sends the signal to the selector switch 66. At this time, the radio-frequency oscillator 65 uses a built-in phase shifter to modulate the phase of the radio-frequency. The frequency may be varied, for example, from 58.5 MHz to 59.9 MHz or from 60.1 MHz to 61.5 MHz. The selector switch 66 receives radio-frequency signals from the radio-frequency oscillators 64 and 65, and then supplies the signals to the RF amplifier 63. When switching the radio-frequency signals from the radio-frequency oscillators 64 and 65 with the selector switch 66, the function generator 67 changes the time ratio, i.e., duty ratio, of the radio-frequency signals. The RF amplifier 62 and the RF amplifier 63 function as radio-frequency sources by amplifying and outputting the supplied radio-frequency signals.

The radio-frequency oscillator 64 generates, for example, a 60-MHz radio-frequency signal, and then sends the signal to the RF amplifier 62 and the selector switch 66. The radio-frequency oscillator 65 generates, for example, a 58.5-MHz radio-frequency signal, and then sends the signal to the selector switch 66. The selector switch 66 switches the 60-MHz radio-frequency signal sent from the radio-frequency oscillator 64 and the 58.5-MHz radio-frequency signal sent from the radio-frequency oscillator 65 in a constant cycle, and then send the signals to the RF amplifier 63. Therefore, the RF amplifier 62 supplies 60-MHz high-frequency electrical power to the feeding point 53. The RF amplifier 63 supplies the high-frequency electrical power of 60 MHz and 58.5 MHz, which are switched in a constant cycle, to the feeding point 54.

The selector switch 66 switches the 60-MHz radio-frequency signal sent from the radio-frequency oscillator 64 and the 58.5-MHz radio-frequency signal sent from the radio-frequency oscillator 65 on the basis of a signal from the function generator 67. The function generator 67 changes the time ratio, i.e., duty ratio, of the switching of the radio-frequency signal according to a signal corresponding to gas conditions, such as gas pressure and gas species. The radio-frequency oscillator 64 uses the phase shifter to shift the phase of the radio-frequency signals to be sent to the phase of the RF amplifier 62 and the selector switch 66 with respect to the radio-frequency signal to be sent to the other. The radio-frequency oscillator 65 is capable of varying the oscillation frequency, for example, from 58.5 MHz to 59.9 MHz or from 60.1 MHz to 61.5 MHz.

However, the discharge electrodes 3a to 3h may receive electrical power from eight respective power supplies 60. Instead, the discharge electrodes 3a to 3h may receive electrical power from less than eight power supplies 60. In such a case, the discharge electrodes 3a to 3h are grouped to correspond to the number of power supplies 60. Moreover, the discharge electrode 3 may be constructed of one ladder-type electrode and may receive electrical power from one power supply 60.

Details of the above-mentioned operation are described in Japanese Unexamined Patent Application, Publication No. 2002-322563. According to the structure and operation, nonuniformity in the plasma generated by, for example, a standing wave at the discharge electrode 3 can be prevented, and then the film deposited over a large area can be made uniform.

Figs. 7A to 7C are a plan view and sectional views illustrating the configuration of the discharge electrode according to the first embodiment of the present invention.

Fig. 7A is a sectional view of the discharge electrode 3a, taken along line BB in Fig. 5. Fig. 7B is a sectional view of the discharge electrode 3a, taken along line AA in Fig. 7A. Fig. 7C is a plan view of the bottom of the discharge electrode 3a in Fig. 7A. Each of the longitudinal structures 21 (21a) of the discharge electrode 3 (3a) includes an electrode main body 35 having a built-in gas-pipe accommodating space 36, a gas pipe 41 accommodated in the gas-pipe accommodating space 36, and a porous body 40. The XYZ directions are the same as those in Fig. 5.

One end section 35a in the longitudinal direction of the electrode main body 35 is connected to one of the lateral structures 20, and the other end section 35b of the electrode main body 35 is connected to the other lateral structure 20. One of the lateral structures 20 is connected to the radio-frequency power feeding path 12a, and the other lateral structure 20 is connected to the radio-frequency power feeding path 12b.

The electrode main body 35 includes an opening 38 in the +Z direction; a gas diffusion path 37 that is provided between the gas-pipe accommodating space 36 and the opening 38 and that connects the gas-pipe accommodating space 36 and the opening 38; and a pair of heating-medium flow paths 34 disposed to sandwich the gas diffusion path 37. One of the heating-medium flow paths 34 is disposed on the +X side of the gas diffusion path 37, and the other heating-medium flow path 34 is disposed on the -X side of the gas diffusion path 37. The porous body 40 covers the opening 38, and has many gas ejection holes 40a penetrating through the porous body 40 from the opening 38 side to the opposite side in the Z direction. Here, the gas-pipe accommodating space 36, the gas diffusion path 37, the opening 38, and the porous body 40 are arranged in the Z direction in this order, and the porous body 40 is disposed furthest on the +Z side. When depositing a film, the substrate 8 held by the counter electrode 2 is disposed on the +Z side with respect to the porous body 40.

The heating-medium flow paths 34, the gas-pipe accommodating space 36, the gas diffusion path 37, and the opening 38 define a space inside the electrode main body 35, which extends from the end section 35a of the electrode main body 35 to the end section 35b in the Y direction. The porous body 40 also extends from the end section 35a to the end section 35b in the Y direction. The gas-pipe accommodating space 36 has a center axis S36 that extends in the Y direction.

The gas pipe 41 includes a pipe main body 42 extending inside the gas-pipe accommodating space 36 from the end section 35a to the end section 35b in the Y direction; and a pipe end section 43 connected to each end of the pipe main body 42. The pipe end section 43 projects from the opening where the gas-pipe accommodating space 36 is open at the end section 35a or the end section 35b. The gas pipe 41 has a gas flow path 41a as an internal space penetrating through the pipe main body 42 and the pipe end sections 43 in the Y direction. The pipe main body 42 has nozzle holes 42c penetrating from a pipe inner surface 42a facing the gas flow path 41a to a pipe outer surface 42b. The pipe end section 43 is provided with an annular groove 43a. The gas pipe 41 has a center axis S41 extending in the Y direction.

The electrode main body 35 has an electrode inner surface 39 facing the gas-pipe accommodating space 36. The electrode inner surface 39 faces the pipe outer surface 42b, with a gap between the electrode inner surface and the pipe outer surface 42b. The electrode inner surface 39 includes an electrode-inner-surface first section 39a, which is a section on the side opposite to the gas diffusion path 37, and an electrode-inner-surface second section 39b, which is a section on the gas diffusion path 37 side. The electrode-inner-surface first section 39a and the electrode-inner-surface second section 39b extend in the Y direction.

The lateral structure 20 includes a header 30, which is a section on the -Z side of the lateral structure 20, and a base 33, which is a section on the +Z side of the lateral structure 20. The header 30 and the base 33 extend in the X direction. The base 33 is connected to the plurality of electrode main bodies 35 at the respective end sections 35a (or end sections 35b). The base 33 and the electrode main body 35 may be integrated into one unit. The base 33 is provided with a heating-medium flow path 34'. The heating-medium flow path 34' is a space extending inside the base 33 in the X direction, and communicates with the respective heating-medium flow paths 34 of the plurality of electrode main bodies 35. The heating-medium flow path 34' of one of the lateral structures 20 communicates with the heating-medium supplying pipe 15a, and the heating-medium flow path 34' of the other lateral structure 20 communicates with the heating-medium supplying pipe 15b.

The header 30 is provided with depressions 31 and a gas flow path 32. The same number of depressions 31 as the number of longitudinal structures 21a connected to the lateral structure 20 is provided, and, therefore, the same number of depressions 31 as the number of the electrode main bodies 35 and the gas pipes 41 is provided (see Fig. 12). The depression 31 has a bottom surface 31a and a sidewall 31b. The gas flow path 32 is a space extending inside the header 30 in the X direction, and communicates with each of the depressions 31. The gas flow path 32 of one of the lateral structures 20 communicates with the raw-gas pipe 16a, and the gas flow path 32 of the other lateral structure 20 communicates with the raw-gas pipe 16b. The header 30 is attached to the end section 35a (or end section 35b) of the electrode main body 35 such that the pipe end section 43 is inserted into the depression 31. At this time an O-ring 49 disposed in the annular groove 43a seals the gap between the pipe end section 43 and the header 30. As the material of the O-ring 49, it is preferable to use Kalrez (trademark) that has excellent gas resistance and high-temperature resistance. The header 30 is attached to each of the plurality of electrode main bodies 35 with bolts 48. Therefore, the headers 30 are removable from the plurality of electrode main bodies 35 and the bases 33.

The discharge electrode 3a has a structure using the porous body 40 in order to make the gas distribution on the substrate 8 uniform so that it is suitable for fabrication of a microcrystalline solar cell, in which the thin film is deposited at high pressure. In this case, if the discharge electrode 3a is dividable for the purpose of maintenance of the nozzle holes 42c, the manufacturing cost of the discharge electrode 3a tends to increase. With the discharge electrode 3a, when removing the header 30 from the electrode main body 35, it is possible to carry out maintenance of the nozzle holes 42c by removing the gas pipe 41 in a direction parallel to the center axis S41. With such a structure, it is possible to suppress the manufacturing cost of the discharge electrode 3a. The gas pipe 41 does not require blast cleaning, and the maintenance cost is thus suppressed.

One end of the gas flow path 41a communicates with the raw-gas pipe 16a via the depressions 31 and the gas flow path 32 of one of the lateral structures 20. The other end communicates with the raw-gas pipe 16b via the depressions 31 and the gas flow path 32 of the other lateral structure 20. Raw gas for film deposition supplied from the raw-gas pipe 16a and the raw-gas pipe 16b flows through the gas flow path 41a. The gas flowing through the gas flow path 41a is ejected from the nozzle holes 42c.

In Fig. 7A, the flow of the gas ejected from the nozzle holes 42c is indicated by arrows. The nozzle holes 42c are small holes arranged with appropriate intervals in the Y direction, and eject gas in a substantially uniform manner from the gas flow path 41a toward the electrode inner surface 39. The gas ejected from the nozzle holes 42c is diffused through a gap between the pipe outer surface 42b and the electrode inner surface 39 in the Y direction, and flows into the gas diffusion path 37. The gas moves in the +Z direction while being diffused through the gas diffusion path 37 in the Y direction, and then reaches the opening 38. Here, the gas diffuses through the opening 38 in the X direction and reaches the porous body 40 because the flow path width (X direction) of the opening 38 is larger than the flow path width (X direction) of the gas diffusion path 37. The gas is ejected from the gas ejection holes 40a into the space between the substrate 8 and the discharge electrode 3a. The porous body 40 is provided so as to cover a large portion of the surface of the substrate 8 side of the longitudinal structures 21a. In this way, the gas can be substantially uniformly supplied to the substrate 8 on the counter electrode 2. As shown in Fig. 7, the porous body 40 may be a porous plate having a relatively small thickness in the Z direction, or may be formed of a block having a relatively large thickness in the Z direction and many smaller holes. Here, since the nozzle holes 42c face the electrode inner surface and not the gas diffusion path 37, the gas ejected from the nozzle holes 42c travels a long distance before reaching the gas diffusion path 37, and the traveling direction of the gas changes while traveling. As a result, diffusion of the gas in the gap between the pipe outer surface 42b and the electrode inner surface 39 is enhanced. It is especially preferable that the nozzle holes 42c face the electrode-inner-surface first section 39a. However, even when they face the electrode-inner-surface second section 39b, the changes in the traveling distance and the traveling direction of the gas are maintained at a certain level.

The porous body 40 is preferably made of a metal that is a non-magnetic material with good heat conductivity and has fluorine resistance when self-cleaning (reactive ion etching). Furthermore, it is preferably a metal that can be easily welded. An example of such a metal is aluminum material (aluminum or aluminum alloy). This is also preferable for the electrode main bodies 35.

The shape of the gas ejection holes 40a is not limited. In addition to a circle, any appropriate shape, such as an oval, a rectangle, a triangle, or a star, may be used. The gas ejected from the gas ejection holes 40a into the space between the discharge electrode 3 (discharge electrode 3a) and the substrate 8 (or the counter electrode 2) contributes to the reaction for film deposition or the reaction for self-cleaning, and generates a production gas by the reaction. The gap 22 between the adjacent longitudinal structures 21a acts as a path for evacuating remaining gas that did not contribute to the reactions or other generated gases. Since evacuation is carried out through the gap 22, it is possible to deposit a uniform film on the substrate 8.

Since the nozzle holes 42c eject gas in a direction (-Z direction) opposite to the substrate 8, the gas flow path from the nozzle holes 42c to the substrate 8 is long and winding. Therefore, the gas is sufficiently diffused before reaching the substrate 8, and the flow distribution and the concentration distribution of the gas on the substrate 8 is made uniform.

One end of the heating-medium flow path 34 is connected to the heating-medium supplying pipe 15a via the heating-medium flow path 34' of one of the lateral structures 20. The other end is connected to the heating-medium supplying pipe 15b via the other lateral structure 20. Since the temperature-controlled heating medium is circulated through the heating-medium flow path 34, the electrode main body 35 can be regulated at a desired temperature. Here, two heating-medium flow paths 34 are provided in one electrode main body 35. However, one or three or more heating-medium flow paths 34 may be provided. The heating-medium flow paths 34 is not required when the electrical power applied between the discharge electrode and the counter electrode is small and when temperature control is not necessarily required.

Fig. 8 is a transparent view of the surroundings of the pipe main body 42 of the discharge electrode shown in Figs. 7A to 7C. The nozzle holes 42c are arranged in the pipe main body 42 in the Y direction at a nozzle pitch L. When the pipe main body 42 is a cylindrical pipe and the nozzle holes 42c are circular, the nozzle diameter d of the nozzle holes 42c is determined so as to satisfy Equation (1):

$$5<\{\pi(D/2)^2\}/\{\pi(d/2)^2\times N\}$$

where D represents the inner diameter of the pipe main body 42 and N represents the number of nozzle holes 42c provided on one pipe main body 42. Equation (1) indicates that a flow path sectional area S1 of the pipe main body 42 is five times larger than the total ejection area S2 of the nozzle holes 42c provided in one pipe main body 42.

Fig. 9 is a graph illustrating the relationship between the sectional area ratio and the flow rate distribution of the discharge electrode 3a. The vertical axis represents the flow rate distribution, and the horizontal axis represents the sectional area ratio S1/S2. The flow rate distribution shown in Fig. 9 represents the difference from the averages of the maximum values and minimum values of the flow rate of the gas ejected from each of the nozzle holes 42c provided in the pipe main body 42, given by:

flow rate distribution = (maximum value of flow rate - minimum value of flow rate)/2/average flow rate

The flow rate distribution increases when the sectional area ratio S1/S2 decreases. When the sectional area ratio S1/S2 becomes less than 5, the flow rate distribution suddenly increases. Therefore, it is important that the sectional area ratio S1/S2 be greater than 5. When the sectional area ratio S1/S2 is greater than 5, the flow rate distribution is maintained below 5%. This is because, when the sectional area ratio S1/S2 is large, the pressure distribution of the gas become uniform along the center axis S41 of the gas flow path 41a, and gas is ejected uniformly from the plurality of nozzle holes 42c.

Here, since the flow path sectional area S1 and the total ejection area S2 each must be a positive value to enable gas molecules to pass through, Equation (1) can be represented as the following Equation (1'):

$$0 < \{\pi(d/2)^2\times N\}/\{\pi(D/2)^2\} < 1/5$$

The pipe main body 42 may be a rectangular pipe or an oval pipe, and the nozzle holes 42c may be rectangular or oval. In such a case, gas is ejected uniformly from the nozzle holes 42c when the flow path sectional area S1 of the pipe main body 42 and the total ejection area S2 of the nozzle holes 42c provided in one pipe main body 42 satisfy the relationship in Equation (1').

When the nozzle holes 42c are circular, the gap distance w between the pipe outer surface 42b and the electrode inner surface 39 is determined to satisfy the following Equation (2):

$$2wL > \pi(d/2)^2$$

where d represents the nozzle diameter d of the nozzle holes 42c and L represents the nozzle pitch L. Equation (2) indicates that the flow path sectional area (2wL) of the gap between the pipe outer surface 42b and the electrode inner surface 39 corresponding to one nozzle hole 42c is greater than the ejection area S of one nozzle hole 42c. When Equation (2) is satisfied, the flow speed of the gas ejected from the nozzle holes 42c becomes smaller than the ejection speed at the nozzle holes 42c while the gas moves toward the gas diffusion path 37 in the gap between the pipe outer surface 42b and the electrode inner surface 39, and thus, the distribution of the gas ejected from the porous body 40 in the X direction becomes uniform.

Here, since the flow path sectional area (2wL) and the ejection area S of each nozzle hole 42c must be positive values in order to enable gas molecules to pass through, Equation (2) can be represented as the following Equation (2'):

$$0 < \{\pi(d/2)^2\}/(2wL) < 1$$

Here, the nozzle holes 42c are not limited to circles, and may be rectangles or ovals. In such a case, gas is ejected uniformly from the nozzle holes 42c when the flow path sectional area (2wL) of the gap between the pipe outer surface 42b and the electrode inner surface 39 associated with one nozzle hole 42c and the ejection area S of one nozzle hole 42c satisfy the relationship in Equation (2').
The upper limit of the gap distance w is restricted by the size of the discharge electrode 3a.
Figs. 10A and 10B are transparent views of the surroundings of the pipe main body 42 of the discharge electrode shown in Figs. 7A to 7C. Figs. 10A and 10B illustrate spacers 44 disposed between the pipe outer surface 42b and the electrode inner surface 39 in order to maintain a constant gap distance w. The spacer 44 shown in Fig. 10A is annular, and is provided around the entire circumference of the pipe outer surface 42b. The spacers 44 shown in Fig. 10B are projections provided on the circumference of the pipe outer surface 42b at equiangular intervals. The spacers 44 are provided in the Y direction at appropriate intervals. A plurality of spacers 44, e.g., four or five, is provided on one pipe main body 42. The spacers 44 may be provided on the pipe outer surface 42b, as shown in Figs. 10A and 10B, or, instead, may be provided on the electrode inner surface 39.
Fig. 11 illustrates the relationship between the flow rate distribution in the discharge electrode 3a and the misalignment of the gas pipe and the center axis of the electrode. The vertical axis represents the flow rate distribution. The horizontal axis represents the ratio of the vertical misalignment of the center axis S36 and the center axis S41 shown in Fig. 7B, to the gap distance w when the center axes S36 and S41 are aligned. Here, the numerator represents the misalignment, and the denominator represents the gap distance w. The flow rate distribution shown in Fig. 11 represents the difference from the averages of the maximum values and minimum values of the flow rate of the gas ejected from each of the plurality of gas ejection holes 40a provided in the porous body 40, given by:

$$\text{flow rate distribution} = (\text{maximum value of flow rate} - \text{minimum value of flow rate})/2/\text{average flow rate}$$

In Fig. 11, the greater the ratio is, the greater the flow rate distribution is. When the ratio is smaller than 25%, the flow rate distribution is maintained below 5%.
Therefore, it is preferable to provided the spacers 44 on the pipe outer surface 42b such that the spacers 44 contact the electrode inner surface 39 before the vertical misalignment of the center axis S36 and the center axis S41 with respect to the center axis S36 exceeds 25% of the gap distance w when the center axes S36 and S41 are aligned. For example, it is preferable that the height of the spacers 44 from the pipe outer surface 42b be in the range between 75% or more and less than 100% of the gap distance w when the center axis S36 and the center axis S41 are aligned.
When the spacers 44 are provided on the electrode inner surface 39, it is preferable that the spacers 44 be provided such that the spacers 44 contact the pipe outer surface 42b before the vertical misalignment of the center axis S36 and the center axis S41 with respect to the center axis S36 exceeds 25% of the gap distance w when the center axes S36 and S41 is aligned. For example, it is preferable that the height of the spacers 44 from the electrode inner surface 39 be in the range between 75% or more and less than 100% of the gap distance w when the center axis S36 and the center axis S41 are aligned.
By constructing the gas pipe 41 with aluminum material (aluminum or aluminum alloy), which is the same material as the electrode main body 35, the gap between the pipe outer surface 42b and the electrode inner surface 39 is prevented from being reduced due to thermal expansion. In addition, by selecting non-magnetic stainless steel for the gas pipe 41, it is possible to reduce costs. Examples of non-magnetic stainless steel are SUS304 and SUS316. Stainless steel is selected in consideration of corrosion resistance against fluorine when performing self-cleaning. The stainless steel is non-magnetic in view of resistance against the plasma. Here, since the linear expansion coefficient $17\times10^{-6}$ of SUS304 is close to the linear expansion coefficient $24\times10^{-6}$ of aluminum material, the gap between the pipe outer surface 42b and the electrode inner surface 39 is prevented from being reduced due to thermal expansion.
The O-ring 49 sealing the gap between the pipe end section 43 and the header 30 may be disposed in the annular groove 43a provided in the pipe end section 43, as shown in Fig. 7B, or may be disposed in an annular groove 31c provided in the sidewall 31b, as shown in Fig. 13. In the configuration shown in Fig. 13, it is preferable that the distance L1 between the bottom surface 31a and the annular groove 31c be greater than 10 mm. The distance L1 is the distance in the direction that the pipe end section 43 is inserted into the depression 31. A gas pipe that has a length of 1 m or greater is used as the gas pipe 41 in order to deposit a film on a substrate 8 with a side of 1 m or longer. Therefore, it is preferable to set the distance L1 greater than 10 mm so that, even when a difference occurs in the thermal expansion of the gas pipe 41 and the electrode main body 35, deformation does not occur in the gas pipe 41 and gas does not leak from the sealed portion. By setting the distance L1 greater than 10 mm, expansion or contraction of the gas pipe 41 of about ±5 mm can be absorbed. It is especially effective to set the distance L1 in this way when the materials of the gas pipe 41 and the electrode main body 35 differ.

Figs. 14A and 14B illustrate a key structure for adjusting the orientation of the nozzle hole 42c on the gas pipe 4. Fig. 14B is a transparent view of the key structure shown in Fig. 7B. The annular spacer 44 is provided on the pipe outer surface 42b, and the annular spacer 44 has a key groove 44a. A key 45 is provided on the electrode main body 35 such that the key 45 projects from the electrode inner surface 39 into the gas-pipe accommodating space 36. When the gas pipe 41 is inserted into the gas-pipe accommodating space 36, the key 45 and the key groove 44a engages, and the orientation of the nozzle hole 42c is adjusted to face the side opposite to the porous body 40, i.e., to face the electrode-inner-surface first section 39a.

The key structure may have the structure shown in Fig. 14A. In this case, the key structure includes a key 45 provided on the outer surface of the pipe end section 43 and a key groove 31d provided on the sidewall 31b. Here, the annular groove 43a is disposed closer to the end than the key 45 is. When the header 30 is attached to the electrode main body 35, the pipe end section 43 is inserted into the depression 31. At this time, the key 45 engages with the key groove 31d, and the orientation of the nozzle hole 42c is adjusted to face the side opposite to the porous body 40, i.e., to face the electrode-inner-surface first section 39a.

Another method of aligning the orientation of the nozzle hole 42c is a method of providing an eye mark 50 indicating the orientation of the nozzle hole 42c on the pipe end section 43 (see Fig. 12).

Furthermore, to easily adjust the orientation of the nozzle hole 42c, the gas pipe 41 may be a rectangular pipe or an oval pipe. Fig. 15A illustrates a case in which the pipe main body 42 is a rectangular pipe and the cross-section of the gas-pipe accommodating space 36 is rectangular. Fig. 15B illustrates a case in which the pipe main body 42 is an oval pipe and the cross-section of the gas-pipe accommodating space 36 is oval. As shown in Fig. 15C, the cross-section of the pipe main body 42 and the cross-section of the gas-pipe accommodating space 36 do not have to match. Even for the pipe main body 42 and the gas-pipe accommodating space 36 having the shapes shown in Figs. 15A to 15C, above-mentioned key structures and spacers 44 may be employed. In Figs. 15A to 15C, the heating-medium flow paths 34 are omitted.

Next, the solar cell fabrication method according to the present invention will be described. Here, a case in which a silicon-based thin-film solar cell is produced using the above-described discharge electrodes and thin-film deposition apparatus will be described. Here, "silicon-based" includes silicon (Si), silicon carbide (SiC), and silicon germanium (SiGe). Here, an example of silicon-based thin film is microcrystalline silicon or amorphous silicon.

Step 1:

The substrate 8, which is transparent like glass, is introduced into the thin-film deposition apparatus 1 and is set on the counter electrode 2. It is preferable that the substrate 8 be, for example, a 1.4 m × 1.1 m soda float glass with a thickness of 4 mm, and that corner chamfering or R-face chamfering be performed on end surfaces of the substrate so as to prevent breaking. A transparent conductive film mainly composed of a tin oxide film is deposited on the surface of the substrate 8 with a thickness of approximately 500 to 800 nm using a thermal CVD apparatus at a deposition temperature of approximately 500°C. When a microcrystalline silicon layer is formed as a bottom photovoltaic layer in a tandem solar cell, a transparent conductive film and an amorphous silicon solar cell layers (p layer, i layer, and n layer) are formed on the substrate 8. Subsequently, the film deposition chamber 6 is set to a predetermined vacuum level (for example, $10^{-6}$ Pa). The heat equalizer plate 5 is controlled such that the temperature of the counter electrode 2 is set constant at, for example, 200°C. The distance between the substrate and the electrode is, for example, 2 to 15 mm; for example, 5 mm is preferable for making the film thickness and the film quality uniform and performing high-speed deposition.

Step 2:

Gas for film deposition is supplied to the space between the discharge electrode 3 and the substrate 8 through the raw-gas pipe 16a, the gas flow path 32, the depressions 31, the gas flow path 41a, the nozzle holes 42c, the gap between the pipe outer surface 42b and the electrode inner surface 39, the gas diffusion path 37, the opening 38, and the porous body 40 (plurality of holes 40a). When depositing a microcrystalline silicon thin film or an amorphous silicon thin film, the gas is, for example, $H_2$+$SiH_4$ ($SiH_4$ partial pressure: 2% to 20%). However, when forming a p layer and an n layer, a dopant is added to the gas. The range of deposition pressure is, for example, 800 to 1800 Pa when depositing a microcrystalline silicon thin film. The range of deposition pressure is 200 to 600 Pa when depositing an amorphous silicon thin film. The gas is supplied through the gas ejection holes 40a and is evacuated from the gap 22.

Step 3:

Predetermined high-frequency electrical power is supplied to the discharge electrode 3 via the radio-frequency power feeding path 12 connected to the output while the impedance at the output of the matching box 13 is matched. In this way, plasma is generated between the discharge electrode 3 and the counter electrode 2, and then a silicon thin film is deposited on the substrate 8. When depositing a microcrystalline silicon thin film, the high-frequency electrical power, the substrate temperature, and the film thickness are, for example, 1 $W/cm^2$, 200°C, and 1.5 to 3 μm, respectively. When depositing an amorphous silicon thin film, the high-frequency electrical power, the substrate temperature, and the film thickness are, for example, 0.2 $W/cm^2$, 200°C, and approximately 300 nm, respectively.

Step 4:

From before film deposition until completing film deposition, the heating medium is made to flow to the heating-medium flow paths 34 provided inside the discharge electrode 3 through the heating medium supplying pipe provided inside the radio-frequency power feeding path 12. In this way, the temperature of the discharge electrode 3 is controlled. The temperature of the electrode main body 35 is controlled at an appropriate temperature between, for example, 50°C to 180°C. In other words, the temperature of the electrode main body 35 is controlled according to the heat balance of the substrate heating temperature during deposition, the plasma input electrical power, and the heat emitted by the film deposition chamber 6 such that warpage of the substrate caused by a temperature difference between the front and back of the substrate 8 is suppressed.

Step 5:

The above-described Steps 1 to 4 are repeated for depositing the p-layer silicon thin film, the i-layer silicon thin film, and the n-layer silicon thin film.

Step 6:

Subsequently, a back-side conductive film of silver or aluminum is formed on the n layer with a sputtering apparatus to produce a solar cell.

The p-layer silicon thin film, the i-layer silicon thin film, and the n-layer silicon thin film may be deposited in different film deposition chambers 6, respectively. Furthermore, the p-layer silicon thin film, the i-layer silicon thin film, and the n-layer silicon thin film may be deposited with different thin-film deposition apparatuses. Other thin films may be interposed therebetween if necessary. For these other films, transparent conductive films, and back-side conductive films, the thin-film deposition apparatus according to the present invention does not have to be used. Although not described in particular, a film etching process using a YAG laser is carried out as a step of the process in order to have a serially integrated structure of the solar cell.

In the above-described solar cell fabrication method, an example of producing one amorphous silicon solar cell or one microcrystalline silicon solar cell is described. However, the present invention is not limited to such an example, and may be also applied to other types of thin-film solar cells, such as a multi-junction solar cell in which one or a plurality of amorphous silicon solar cells and one or a plurality of microcrystalline silicon solar cells are stacked.

Moreover, the present invention may also be applied to a solar cell produced on a non-transmissive substrate, such as a metal substrate in which light is incident from the side opposite to a substrate.

The gas ejected in the +Z direction from the plurality of gas ejection holes 40a to the substrate 8 contributes to plasma generation, while part of the gas moves below the adjacent longitudinal structure 21a. However, it is presumed that most of the gas is evacuated to the gap 22 between the adjacent longitudinal structures 21a. Since the plurality of gas ejection holes 40a (porous body 40) that supply the gas and the gap 22 through which the gas is evacuated are close to each other, the retention time of gas in the plasma is short. In this way, it becomes possible to suppress the growth of nano-clusters that inhibit the generation of a film having excellent film quality and their inclusion of the nano-clusters into the film.

With the discharge electrode 3 of the present invention, since the gap 22 between adjacent longitudinal structures 21a is smaller than the distance between the electrode and the substrate, e.g., 2 to 4 mm, and a flat plate or block porous body is used as the porous body 40, the counter electrode 2 side of the discharge electrode 3 can be substantially flattened. In this way, the generation of plasma can be made more uniform, and thus the film thickness and film quality can be made more uniform.

As described above, according to the present invention, the occurrence of a film thickness distribution and a film quality distribution can be suppressed even when film deposition is carried out in the condition of narrow gap between the substrate and the electrode and the high deposition pressure is increased. Moreover, by performing high-speed deposition while suppressing the generation of a film thickness distribution and a film quality distribution, productivity can be improved.

[Second Embodiment]

Next, the configuration of a thin-film deposition apparatus according to a second embodiment of the present invention will be described. In this embodiment, the configuration of the discharge electrode 3 differs from that in the first embodiment.
The configuration of the thin-film deposition apparatus according to the second embodiment of the present invention and the configuration associated with the high-frequency electrical power supply in the thin-film deposition apparatus according to the second embodiment of the present invention are the same as those in the first embodiment shown in Figs. 4 to 6. Therefore, descriptions thereof are omitted.
Fig. 16 is a lateral sectional view (B-B cross-section in Fig. 5) of a longitudinal structure of a discharge electrode according to the second embodiment of the present invention. The XYZ directions are the same as those in Fig. 5. According to the longitudinal structure 21 (21a') of the second embodiment, the electrode main body 35 corresponding to the longitudinal structure 21 (21a) of the first embodiment can be separated into an electrode-main-body first section 46 that is a section on the +Z side, and an electrode-main-body second section 47 that is a section on the -Z side. Here, the electrode-main-body first section 46 and the base 33 are integrated; the base 33 and the header 30 are integrated; and the gas pipe 41 and the header 30 are integrated. In other words, the discharge electrode 3a of the second embodiment has the same structure as the discharge electrode 3a of the first embodiment, except that the electrode-main-body second section 47 is removable from the structure including the porous body 40, the electrode-main-body first section 46, the base 33, the header 30, and the gas pipe 41. In Fig. 16, the heating-medium flow paths 34 are omitted.
The electrode-main-body first section 46 includes the opening 38, the gas diffusion path 37, and the electrode-inner-surface second section 39b. The porous body 40 covers the opening 38. The electrode-main-body second section 47 includes the electrode-inner-surface first section 39a. The electrode-main-body second section 47 is attached in a removable manner to the electrode-main-body first section 46 with bolts 48. When the electrode-main-body second section 47 is attached to the electrode-main-body first section 46, the gas-pipe accommodating space 36, which is an inner space of the electrode main body 35, is formed. The gas-pipe accommodating space 36 is a space interposed between the electrode-main-body first section 46 and the electrode-main-body second section 47 for accommodating the pipe main body 42.
Since the solar cell fabrication method according to the second embodiment is the same as that according to the first embodiment, except for the discharge electrode shown in Fig. 16, descriptions thereof are omitted.
Since the discharge electrode 3a in the second embodiment can be separated, maintenance of the nozzle hole 42c can be easily carried out.

[Third Embodiment]

Next, the configuration of a thin-film deposition apparatus according to a third embodiment of the present invention will be described. In this embodiment, the configuration of the discharge electrode 3 differs from those according to the first and second embodiments.
The configuration of the thin-film deposition apparatus according to the third embodiment of the present invention and the configuration associated with the high-frequency electrical power supply in the thin-film deposition apparatus according to the third embodiment of the present invention are the same as those in the first embodiment shown in Figs. 4 to 6. Therefore, descriptions thereof are omitted.
Fig. 17 is a lateral sectional view (B-B cross-section in Fig. 5) of a discharge electrode according to the third embodiment of the present invention. The XYZ directions are the same as those in Fig. 5. The plurality of longitudinal structures 21 (21b) of the discharge electrode 3a of the third embodiment each include an electrode main body 71, which is a section on the +Z side; a gas block 76, which is a section on the -Z side; and a porous body 40', which is similar to the porous body 40. Each of the electrode main body 71 and the gas block 76 has one end connected to one of the lateral structures 20 and the other end connected to the other lateral structure 20. The former lateral structure 20 is connected to the radio-frequency power feeding path 12a, and the latter lateral structure 20 is connected to the radio-frequency power feeding path 12b.
The electrode main body 71 includes an opening 72 that is open toward the counter electrode 2 where the substrate 8 is held; an attachment section 73 that is disposed on the side opposite to the opening 72; a gas diffusion path 74 that is provided between the opening 72 and the attachment section 73 and communicates with the opening 72; and an opening 75 where the gas diffusion path 74 opens at the attachment section 73; and a pair of heating-medium flow paths 80 that are disposed so as to sandwich the gas diffusion path 74. One of the heating-medium flow paths 80 is disposed on the +X side of the gas diffusion path 74, and the other heating-medium flow path 80 is disposed on the -X side of the gas diffusion path 74. The porous body 40' covers the opening 72 and is provided with gas ejection holes 40a' that penetrate the porous body 40' in the Z direction from the opening 72 side to the opposite side. Here, the attachment section 73, the gas diffusion path 74, the opening 72, and the porous body 40' are arranged in the Z direction in this order. The porous body 40' is disposed furthest on the +Z side. When depositing a film, the substrate 8 held by the counter electrode 2 is disposed on the +Z side of the porous body 40'. The opening 72, the gas diffusion path 74, and the heating-medium flow path 80 define a space extending in the Y direction inside the electrode main body 71 from one end of the electrode main body 71 to the other end. One end of the heating-medium flow path 80 is connected to the heating-medium supplying pipe 15a and the other end is connected to the heating-medium supplying pipe 15b so as to circulate the heating medium. The opening 75 and the porous body 40' also extend in the Y direction from one end of the electrode main body 71 to the other end. The attachment section 73 is a depressed groove extending in the Y direction from one end of the electrode main body 71 to the other end. The opening 75 opens at the bottom surface of this groove.

The gas block 76 includes a gas flow path 77; an attachment section 78; and nozzle holes 79 that are disposed between the gas flow path 77 and the attachment section 78 to communicate with the gas flow path 77, and open at the attachment section 78. The gas flow path 77, the nozzle holes 79, and the attachment section 78 are arranged in the Z direction in this order. The attachment section 78 is disposed furthest on the +Z side. The gas flow path 77 is a space extending inside the gas block 76 in the Y direction from one end of the gas block 76 to the other end. One end of the gas flow path 77 communicates with the raw-gas pipe 16a and the other end communicates with the raw-gas pipe 16b so as to circulate the gas. The nozzle holes 79 extend in the Z direction, and are arranged in the Y direction at appropriate intervals. The attachment section 78 is a projecting ridge extending in the Y direction from one end of the gas block 76 to the other end. The nozzle holes 79 open at the top surface of the ridge.

The gas block 76 is attached to the electrode main body 71 such that the attachment section 73 and the attachment section 78 engage. Since the gas block 76 is secured to the electrode main body 71 with bolts 48, the gas block 76 is removable from the electrode main body 71. With the gas block 76 being attached to the electrode main body 71, the bottom surface of the attachment section 73 and the top surface of the attachment section 78 closely contact each other, and the nozzle holes 79 communicate with the gas diffusion path 74.

In Fig. 17, the gas flow is indicated by arrows. The gas ejected into the gas diffusion path 74 through the raw-gas pipe 16a, the gas flow path 77, and the nozzle holes 79 moves in the +Z direction while being diffused in the Y direction through the gas flow path 77, and then reaches the opening 72. Here, the gas diffuses through the opening 72 in the X direction to reache the porous body 40' because the flow path width (X direction) of the opening 72 is larger than the flow path width (X direction) of the gas diffusion path 74. The gas is ejected from the gas ejection holes 40a' into the space between the substrate 8 and the discharge electrode 3a. The porous body 40' is provided so as to cover a large portion of the surface of the substrate 8 side of the longitudinal structures 21b. In this way, the gas can be substantially uniformly supplied to the substrate 8 on the counter electrode 2.

As shown in Fig. 17, the porous body 40' may be a porous plate having a relatively small thickness in the Z direction or may be formed of a block having a relatively large thickness in the Z direction and having many smaller holes. The porous body 40' enables gas to be supplied more uniformly to the substrate 8.

The porous body 40' is preferably made of a metal that is a non-magnetic material with good heat conductivity and has fluorine resistance when performing self-cleaning (reactive ion etching). It is preferably a metal that can be easily welded. An example of such a metal is aluminum material (aluminum or aluminum alloy). This is also preferable for the electrode main body 71 and the gas block 76.

The shape of the gas ejection holes 40a' is not limited. In addition to a circle, any appropriate shape, such as an oval, a rectangle, a triangle, or a star, may be used. The gas ejected from the gas ejection holes 40a' into the space between the discharge electrode 3 (discharge electrode 3a) and the substrate 8 (or the counter electrode 2) contributes to the reaction for film deposition or the reaction for self-cleaning, and generates a product gas by the reaction. The gap 22 between adjacent the longitudinal structures 21a acts as a path for evacuating remaining gas that did not contribute to the reactions or generated gases. Since evacuation is carried out through the gap 22, it is possible to deposit a uniform film on the substrate 8.

It is preferable that the flow path sectional area of the gas flow path 77 be five times larger than the total ejection area of the nozzle holes 79 communicating with a single gas flow path 77. In this way, gas is uniformly ejected from the plurality of nozzle holes 79.

Since the solar cell fabrication method according to the third embodiment is the same as that according to the first embodiment, except for the discharge electrode shown in Fig. 17, descriptions thereof are omitted.

In the third embodiment, the attachment section 73, which is an engagement structure on the electrode main body 71 side, has a depressed structure, and the attachment section 78, which is an engagement structure on the gas block 76 side, has a protruding structure. However, the depression and protrusion may be switched.

The discharge electrode 3a according to the third embodiment has a structure using the porous body 40' in order to make the gas distribution on the substrate 8 uniform so that it is suitable for production of a microcrystalline solar cell at high depostion pressure. Also for the discharge electrode 3a in the third embodiment, since the gas block 76 and the electrode main body 71 can be separated, maintenance of the nozzle holes 79 can be easily carried out. Since the discharge electrode 3a in the first and second embodiments does not have an engagement structure that requires highly precise processing, like the discharge electrode 3a in the third embodiment, manufacturing costs are reduced.

## Claims

1. A discharge electrode comprising:

   two lateral structures that are substantially parallel to each other and extend in a first direction; and
   a plurality of longitudinal structures that are provided between the two lateral structures, are substantially parallel to each other, and extend in a second direction substantially orthogonal to the first direction,

   wherein the plurality of longitudinal structures each include
   an electrode main body whose first end is connected to one of the lateral structures and whose second end, which is the end opposite to the first end, is connected to the other lateral structure,
   a gas pipe disposed in a gas-pipe accommodating space provided inside the electrode main body, and
   a porous body,
   wherein the electrode main body includes a first opening open at a counter electrode holding a substrate and a gas diffusion path provided between the gas-pipe accommodating space and the first opening to connect the gas-pipe accommodating space and the first opening,
   wherein the first opening is covered by the porous body,
   wherein the gas pipe has a nozzle hole group that penetrates from a pipe inner surface to a pipe outer surface of the gas pipe,
   wherein the gas pipe, the gas-pipe accommodating space, the gas diffusion path, and the first opening extend in the second direction,
   wherein the electrode main body has an electrode inner surface that faces the gas-pipe accommodating space and opposes the pipe outer surface, and
   wherein the nozzle hole group is arranged in the second direction in the gas pipe.

2. The discharge electrode according to Claim 1,
   wherein the nozzle hole group faces the electrode inner surface.

3. The discharge electrode according to Claim 2,
   wherein the nozzle hole group is arranged in the second direction at a nozzle pitch L, and
   wherein a gap distance w between the pipe outer surface and the electrode inner surface and an ejection area S of one nozzle hole of the nozzle hole group satisfy the following equation:

$$0 < S/(2wL) < 1.$$

4. The discharge electrode according to Claim 2 or 3, further comprising:

   a spacer disposed between the electrode inner surface and the pipe outer surface.

5. The discharge electrode according to Claim 4,
   wherein the gas-pipe accommodating space has a first center axis,
   wherein the gas pipe has a second center axis, and
   wherein the spacer is provided on the pipe outer surface such that the spacer contacts the electrode inner surface before misalignment of the first center axis and the second center axis with respect to a direction orthogonal to the first center axis exceeds 25% of a gap distance w1 between the pipe outer surface and the electrode inner surface when the first center axis and the second center axis are aligned.

6. The discharge electrode according to Claim 4, wherein the gas-pipe accommodating space has a first center axis, wherein the gas pipe has a second center axis, and wherein the spacer is provided on the electrode inner surface such that the spacer contacts the pipe outer surface before misalignment of the first center axis and the second center axis with respect to a direction orthogonal to the first center axis exceeds 25% of a gap distance w1 between the pipe outer surface and the electrode inner surface when the first center axis and the second center axis are aligned.

7. The discharge electrode according to one of Claims 1 to 6, wherein a ratio S2/S1 of a flow path sectional area S1 of the gas pipe to a total ejection area S2 of the nozzle hole group provided on each gas pipe is greater than 0 and smaller than 1/5.

8. The discharge electrode according to one of Claims 1 to 7, wherein the material of the gas pipe and the electrode main body is an aluminum material.

9. The discharge electrode according to one of Claims 1 to 7, wherein the material of the electrode main body is an aluminum material, and the material of the gas pipe is non-magnetic stainless steel.

10. The discharge electrode according to one of Claims 1 to 9, wherein said one of the lateral structures includes a header extending in the first direction, the gas pipe includes a pipe end section protruding from the gas-pipe accommodating space at the first end, the header includes a depression and a gas flow path communicating with the depression, the header is attached to the first end in a removable manner such that the pipe end section is inserted into the depression, and the gas pipe communicates with the gas flow path through the pipe end section and the depression.

11. The discharge electrode according to Claim 10, wherein the depression has a bottom surface and a sidewall having an annular groove, an O-ring for sealing the gap between the depression and the pipe end section is disposed in the annular groove, and a gap is provided between the bottom surface and the annular groove in the direction in which the pipe end section is inserted into the depression.

12. The discharge electrode according to Claim 10 or 11, wherein a key is provided on the pipe end section, and a key groove that engages with the key is provided in the depression.

13. The discharge electrode according to one of Claims 1 to 9, wherein the electrode main body includes a first section and a second section that is attached to the first section in a removable manner such that the first section and the second section sandwich the inner space, the first section includes the first opening, the gas diffusion path, and a section of the electrode inner surface on the side of the gas diffusion path, and the second section includes a section of the electrode inner surface on the side opposite to the gas diffusion path.

14. The discharge electrode according to Claim 1 or 2, further comprising:

a spacer disposed between the electrode inner surface and the pipe outer surface,

wherein the spacer is provided on the gas-pipe outer surface, wherein a key is provided on the electrode inner surface, and wherein a key groove that engages with the key is provided on the spacer.

15. The discharge electrode according to one of Claims 1 to 14, wherein an eye mark indicating the position of the nozzle hole group is provided on the gas-pipe outer surface.

16. A discharge electrode comprising:

two lateral structures that are substantially parallel to each other and extend in a first direction; and
a plurality of longitudinal structures that are provided between the two lateral structures, are substantially parallel to each other, and extend in a second direction substantially orthogonal to the first direction,

wherein the plurality of longitudinal structures each include
an electrode main body having one end connected to one of the lateral structures and the other end connected to the other lateral structure, the electrode main body extending in the second direction,
a gas block having one end connected to said one of the lateral structures and the other end connected to the other lateral structure, the gas block extending in the second direction, and
a porous body,
wherein the electrode main body includes a first opening open at a counter electrode holding a substrate; a first attachment section disposed on a side opposite to the first opening; a gas diffusion path provided between the first opening and the first attachment section and communicating with the first opening; and a second opening where the gas diffusion path opens at the first attachment section,
wherein the first opening, the first attachment section, the gas diffusion path, and the second opening extend in the second direction,
wherein the first opening is covered by the porous body,
wherein the gas block includes a gas flow path provided inside the gas block; a second attachment section; and a nozzle hole group which is provided between the gas flow path and the second attachment section to communicate with the gas flow path and opens at the section attachment section,
wherein the gas flow path and the second attachment section extend in the second direction,
wherein the nozzle hole group is arranged on the gas block in the second direction, and
wherein the gas block is attached to the electrode main body in a removable manner such that the first attachment section and the second attachment section engage and such that the nozzle hole group communicates with the gas diffusion path.

**17.** A thin-film deposition apparatus comprising:

a film deposition chamber;
a discharge electrode according to one of Claims 1 to 16, disposed inside the film deposition chamber; and
a counter electrode opposing the discharge electrode and being disposed inside the film deposition chamber.

**18.** A fabrication method of a solar cell using a thin-film deposition apparatus,
wherein the thin-film deposition apparatus includes
a film deposition chamber;
a discharge electrode according to one of Claims 1 to 17, disposed inside the film deposition chamber; and
a counter electrode opposing the discharge electrode and being disposed inside the film deposition chamber,
the method comprising the steps of:

(a) supporting a substrate by the counter electrode;
(b) introducing deposition gas to the film deposition chamber through the gas pipe, the nozzle hole group, the gas diffusion path, and the porous body; and
(c) depositing thin film for a solar cell by applying electrical power between the discharge electrode and the counter electrode while introducing the gas.

FIG. 1

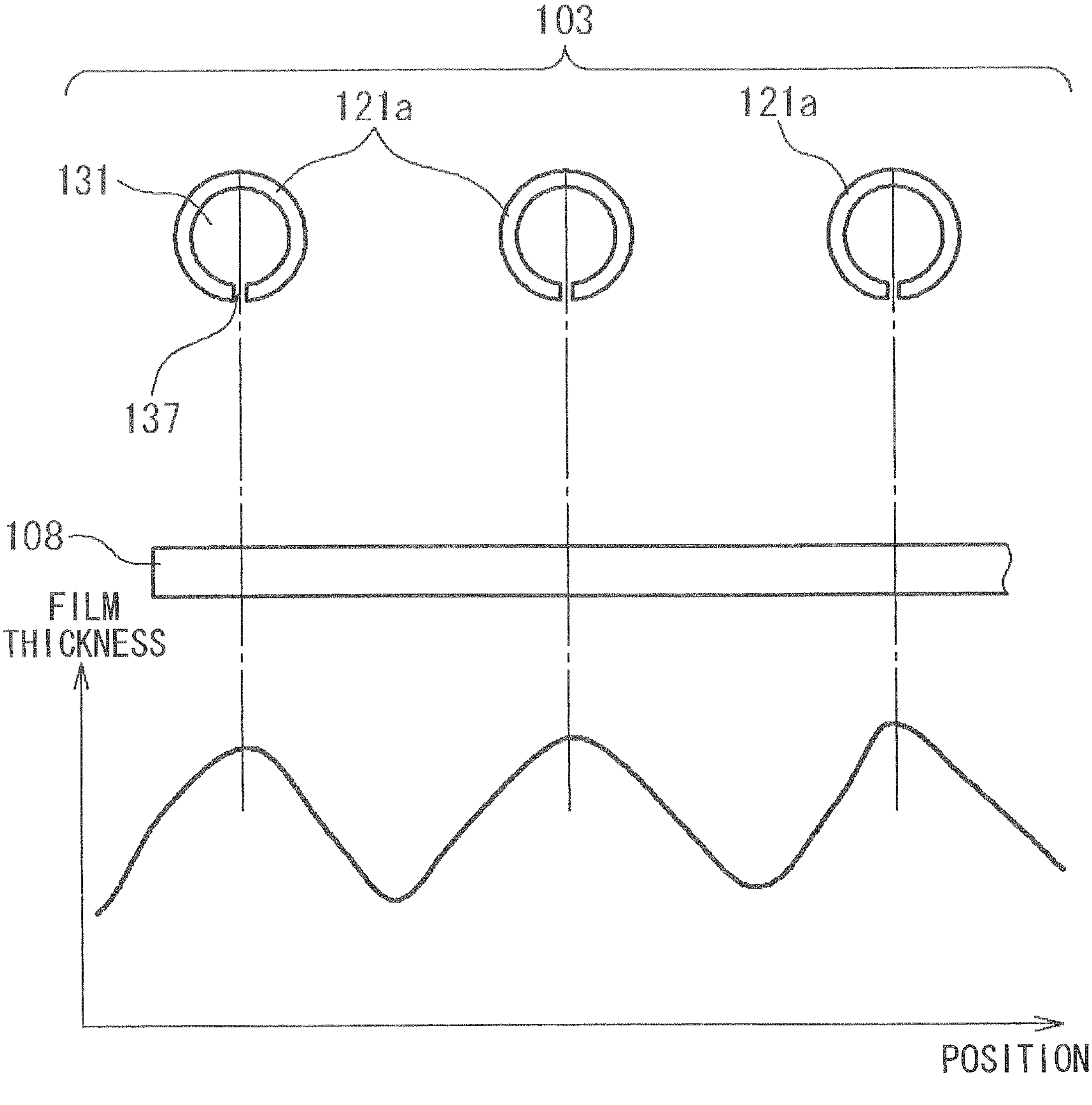

FIG. 2

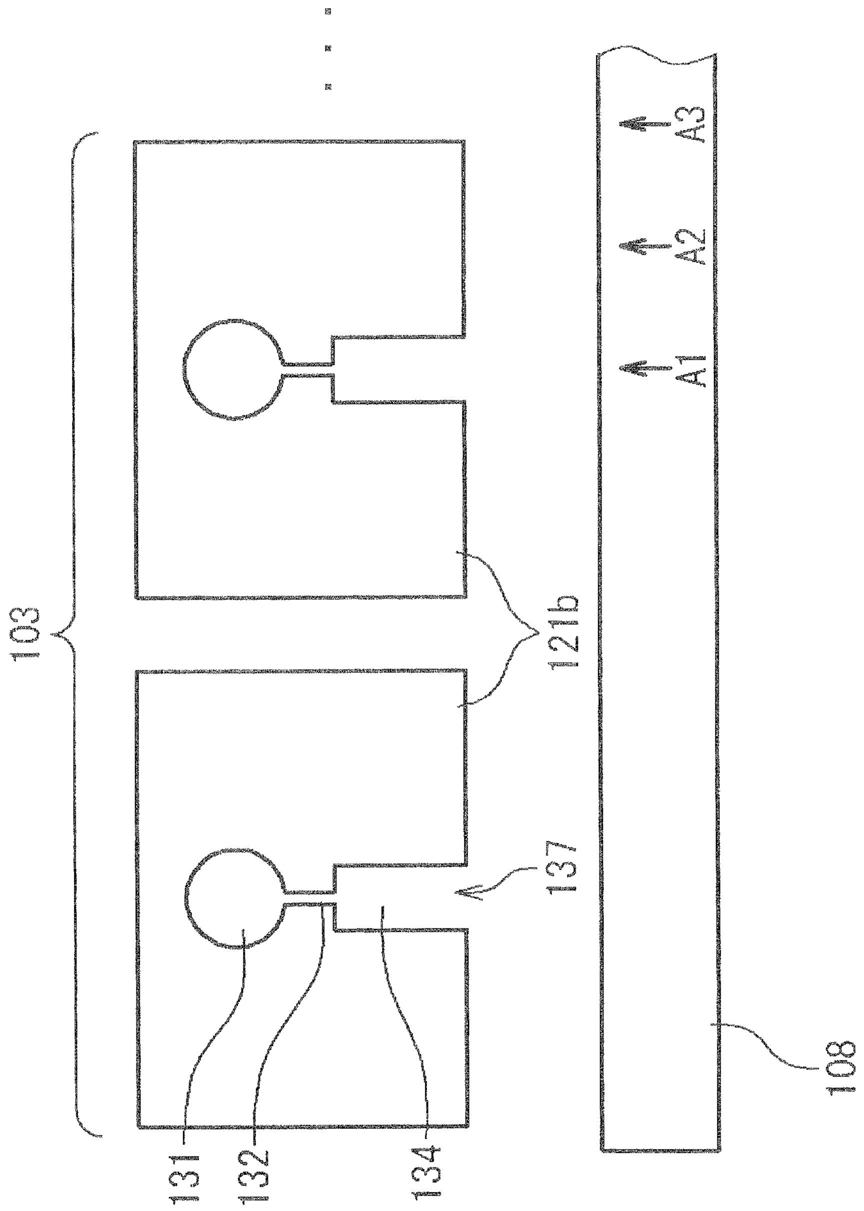

FIG. 3

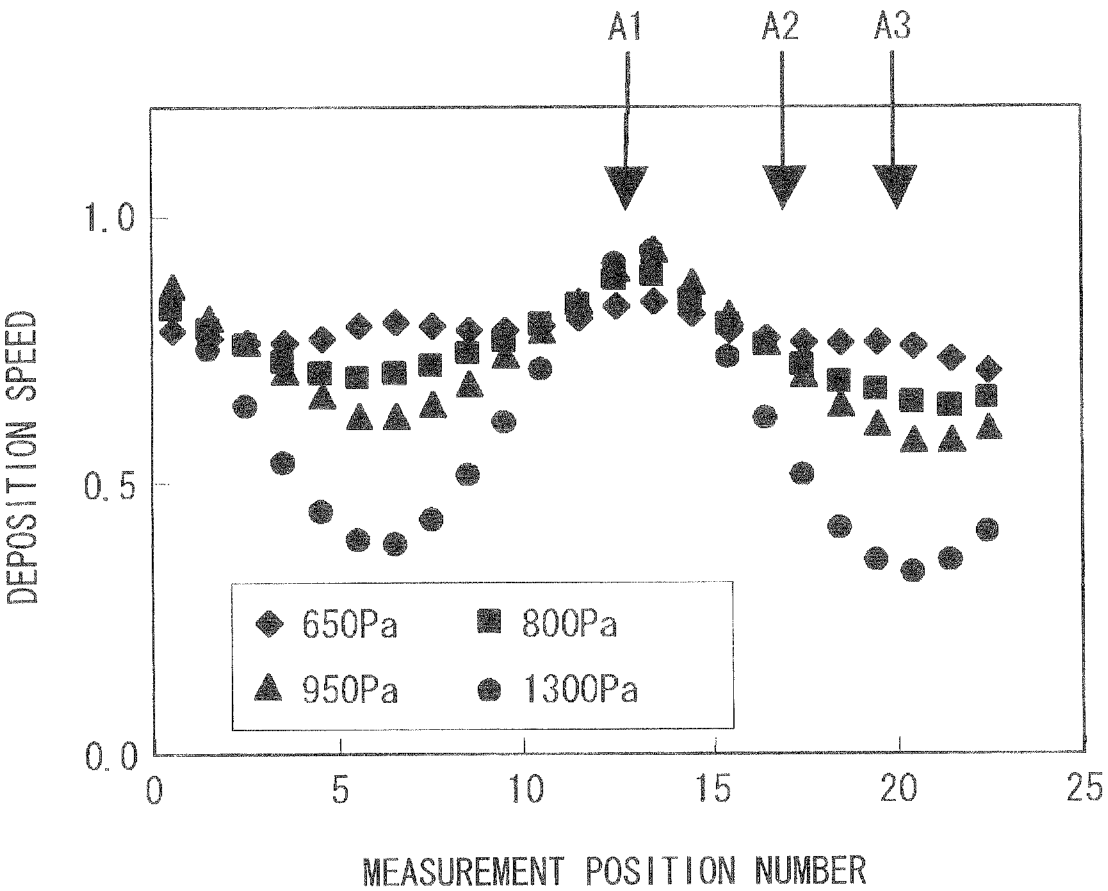
A1
A2
A3
DEPOSITION SPEED
1.0
0.5
0.0
0
5
10
15
20
25
MEASUREMENT POSITION NUMBER
650Pa
800Pa
950Pa
1300Pa

FIG. 4

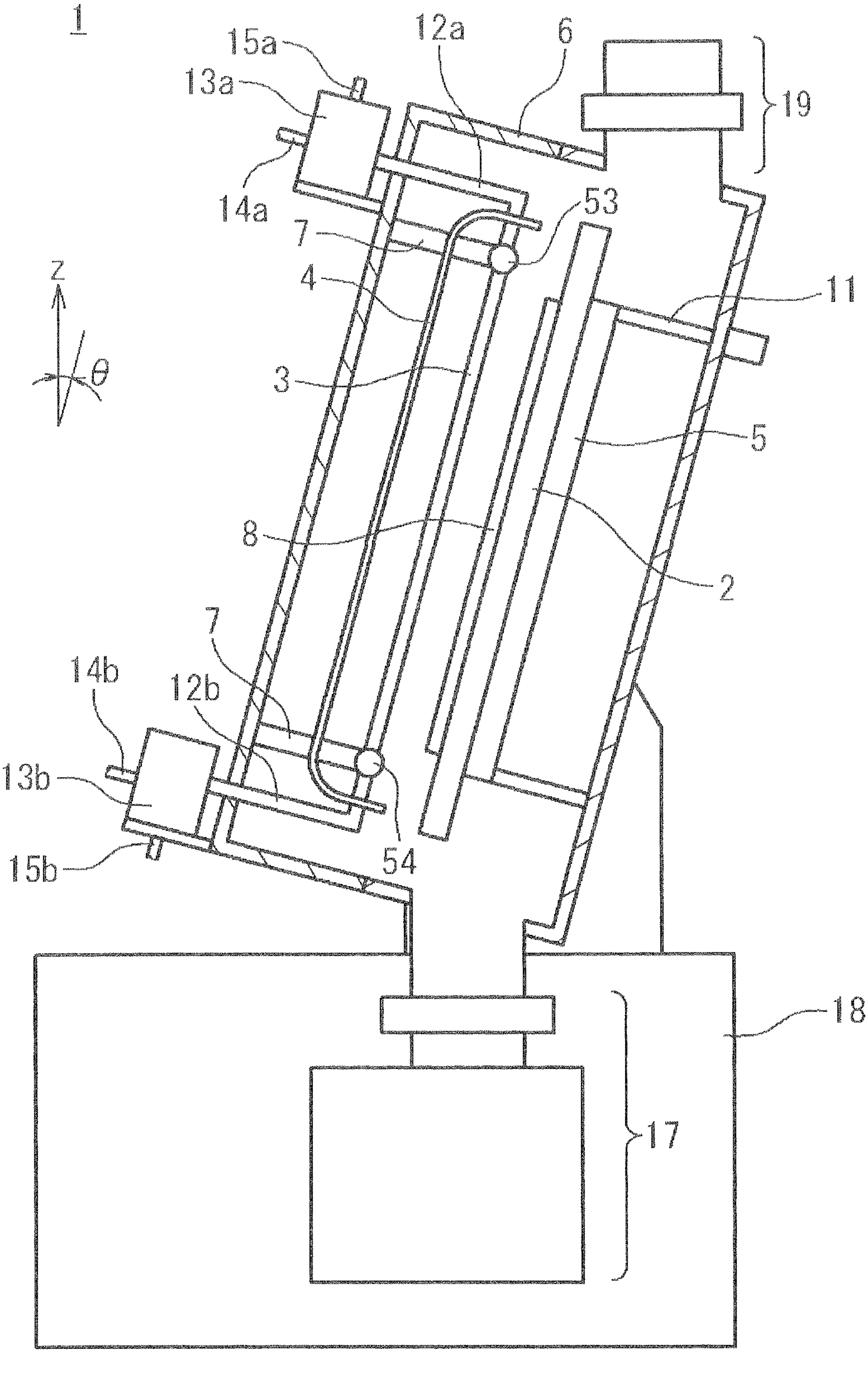

FIG. 5

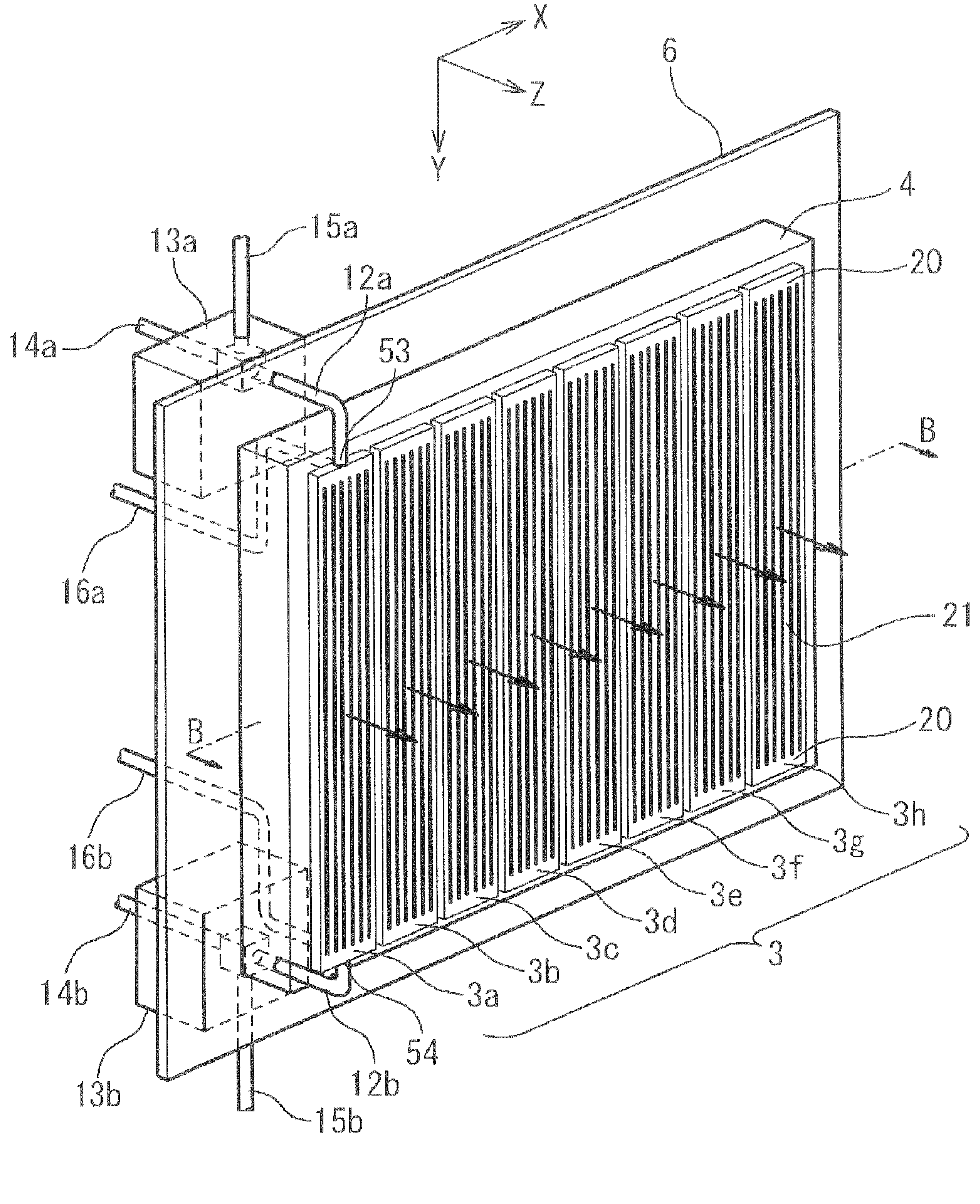
X
Z
Y
6
4
20
13a
15a
12a
14a
53
B
16a
21
20
B
3h
16b
3g
3f
3e
3d
3c
3b
3a
3
14b
54
13b
12b
15b

FIG. 6

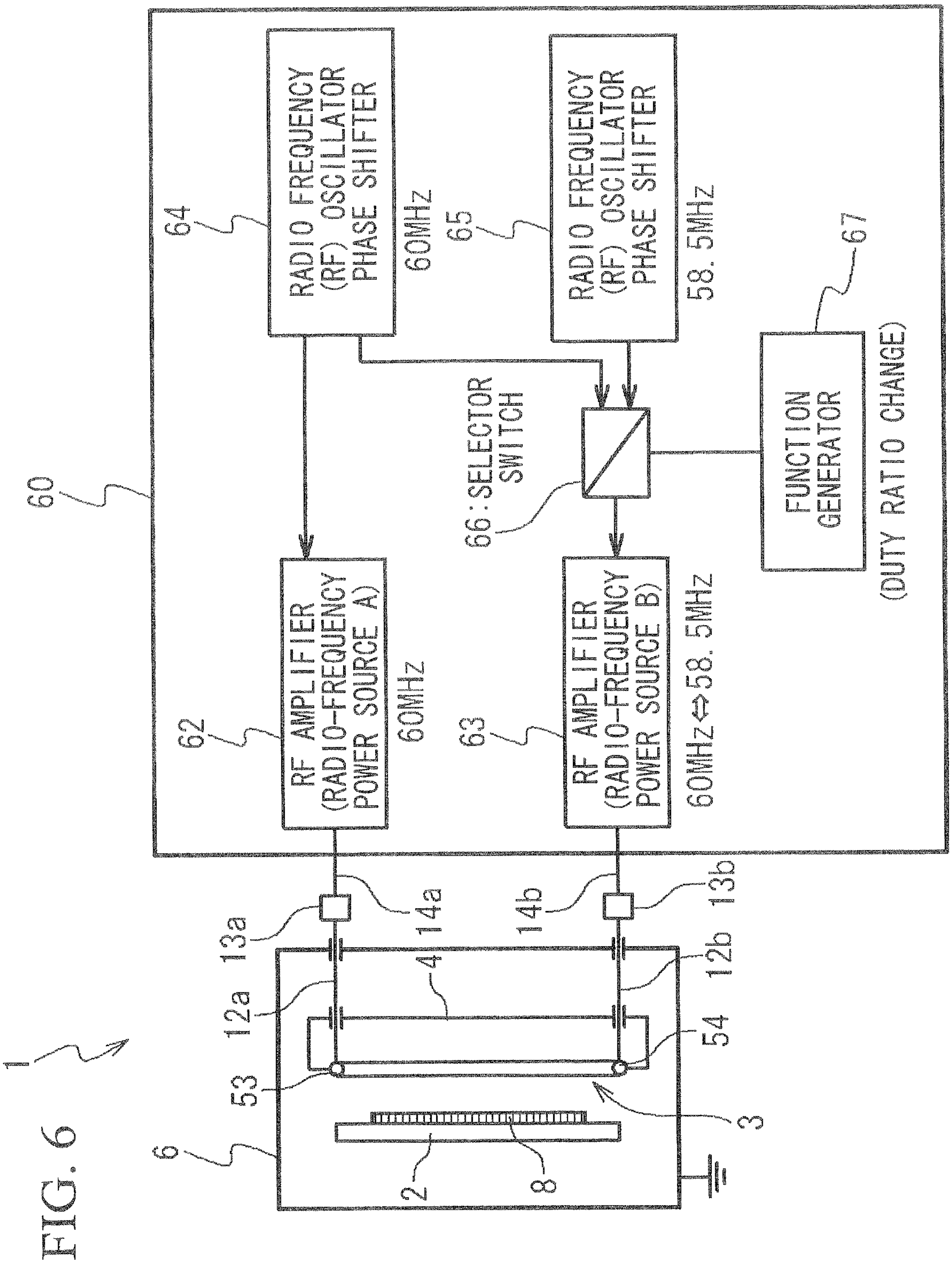
RADIO FREQUENCY
(RF) OSCILLATOR
PHASE SHIFTER
60MHz
RADIO FREQUENCY
(RF) OSCILLATOR
PHASE SHIFTER
58. 5MHz
66: SELECTOR
SWITCH
FUNCTION
GENERATOR
(DUTY RATIO CHANGE)
RF AMPLIFIER
(RADIO-FREQUENCY
POWER SOURCE A)
60MHz
RF AMPLIFIER
(RADIO-FREQUENCY
POWER SOURCE B)
60MHz⇔58. 5MHz
60
62
63
64
65
67
1
2
3
4
6
8
12a
12b
13a
13b
14a
14b
53
54

FIG. 7A

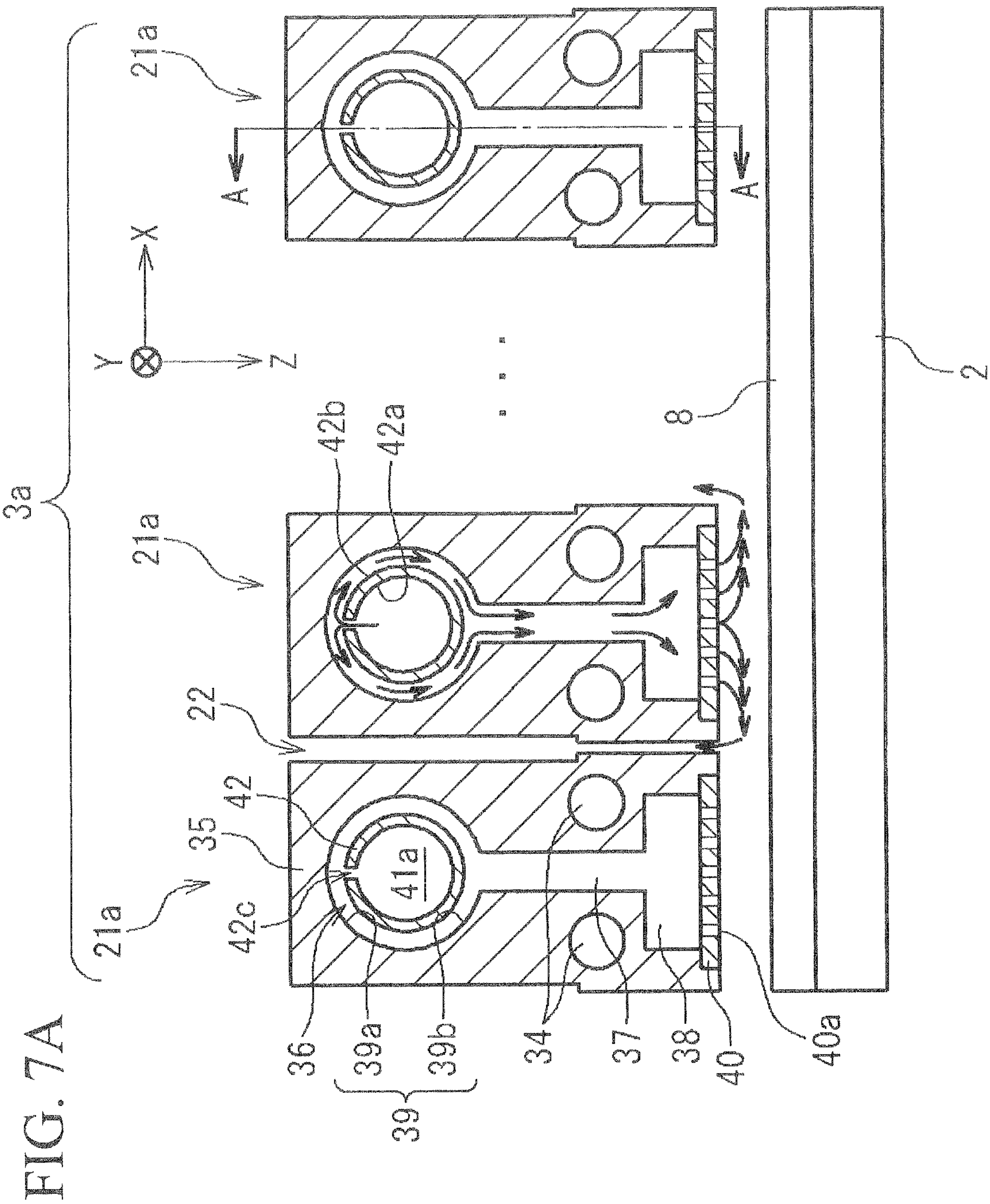
3a
21a
21a
21a
22
35
42
42c
41a
42b
42a
36
39a
39b
39
34
37
38
40
40a
8
2
A
A
X
Y
Z

FIG. 7B

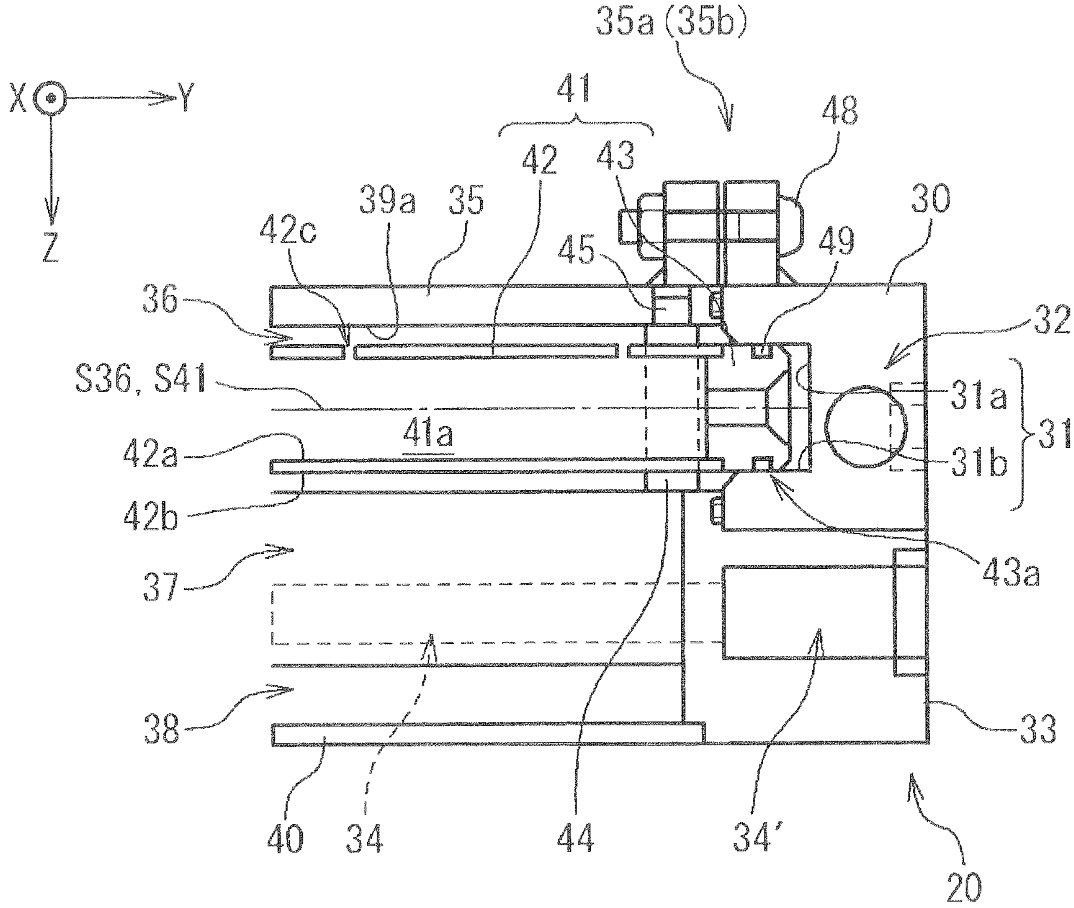
35a (35b)
41
48
X
Y
Z
42
43
39a
35
42c
45
30
49
36
32
S36, S41
31a
31
41a
42a
31b
42b
43a
37
38
33
40
34
44
34'
20

FIG. 7C

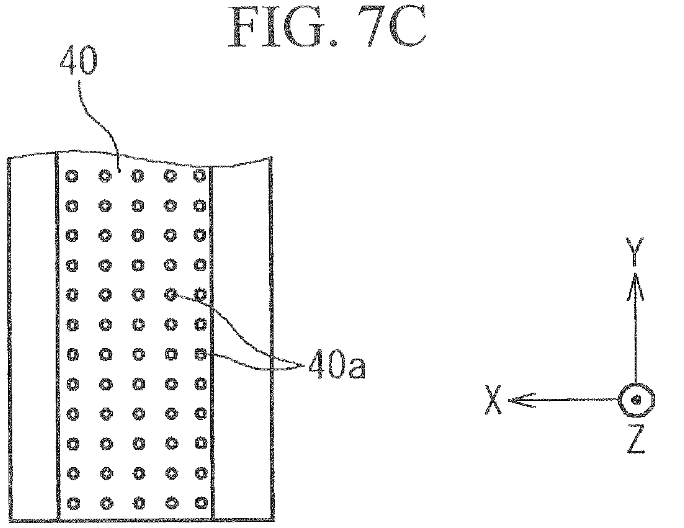
40
Y
40a
X
Z

FIG. 8

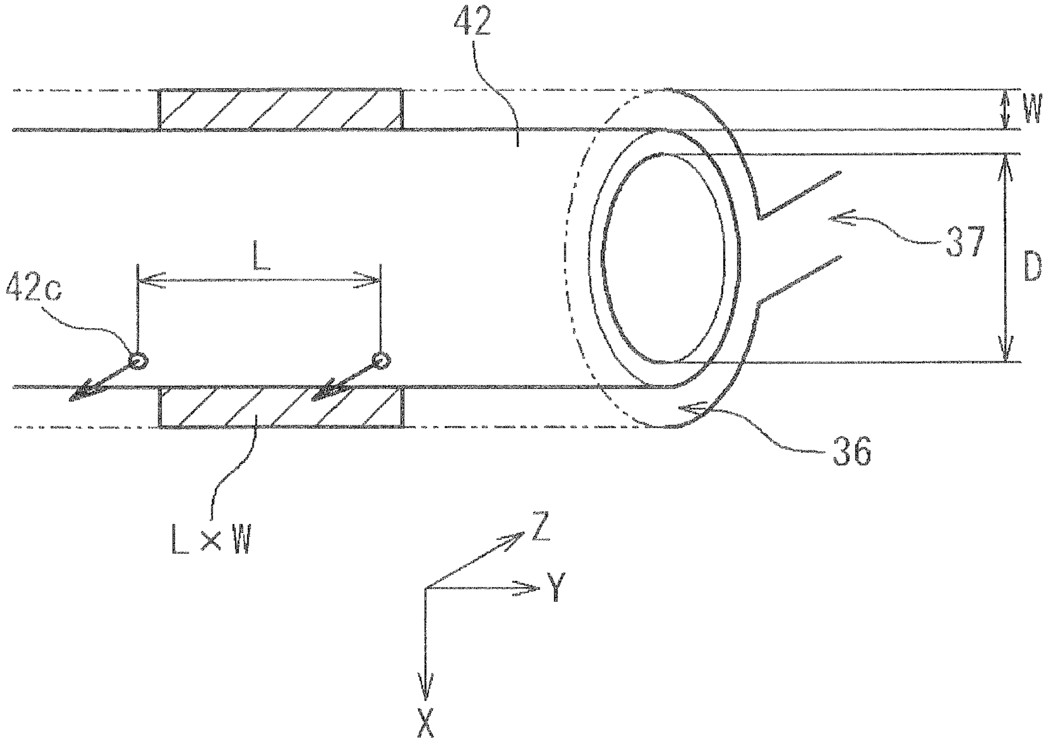
42
W
37
D
L
42c
36
L × W
Z
Y
X

FIG. 9

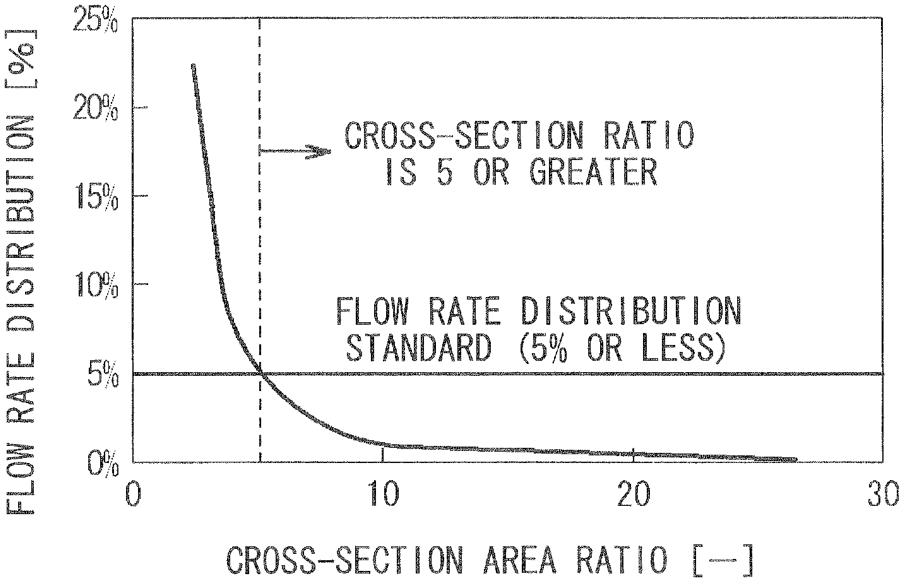
FLOW RATE DISTRIBUTION [%]
25%
20%
15%
10%
5%
0%
CROSS-SECTION RATIO
IS 5 OR GREATER
FLOW RATE DISTRIBUTION
STANDARD (5% OR LESS)
0
10
20
30
CROSS-SECTION AREA RATIO [—]

FIG. 10A

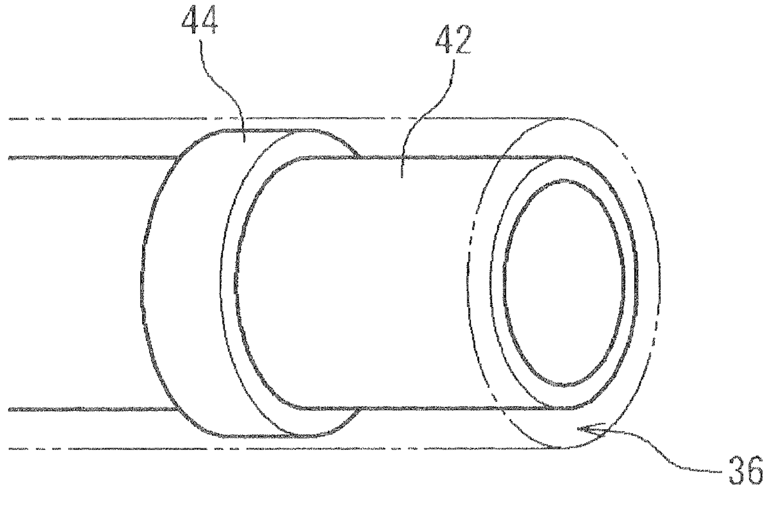


FIG. 10B

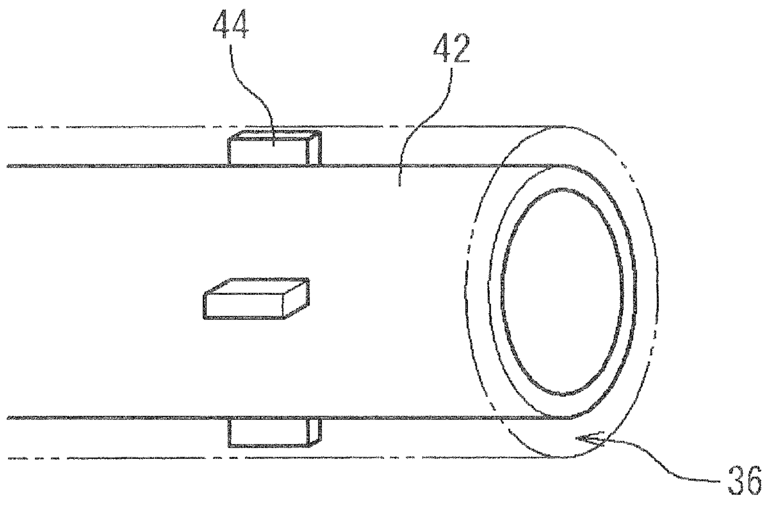

FIG. 11

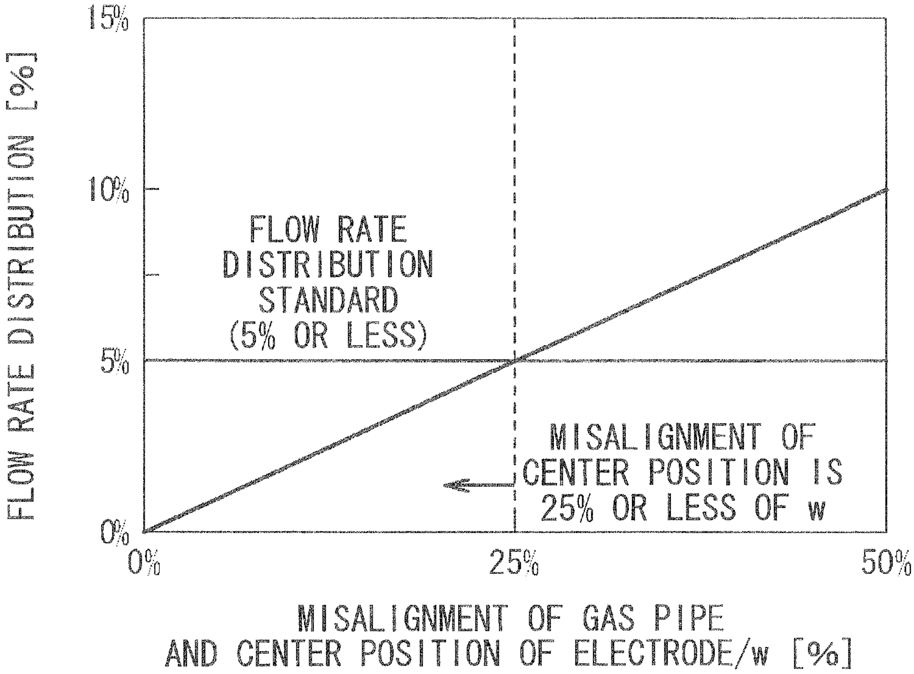
15%
10%
5%
0%
FLOW RATE DISTRIBUTION [%]
FLOW RATE
DISTRIBUTION
STANDARD
(5% OR LESS)
MISALIGNMENT OF
CENTER POSITION IS
25% OR LESS OF w
0%
25%
50%
MISALIGNMENT OF GAS PIPE
AND CENTER POSITION OF ELECTRODE/w [%]

FIG. 12

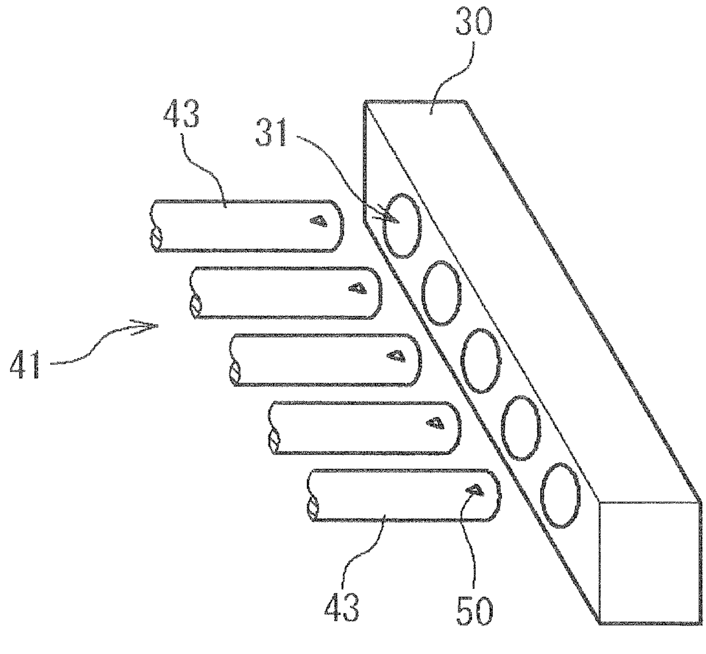
30
43
31
41
43
50

FIG. 13

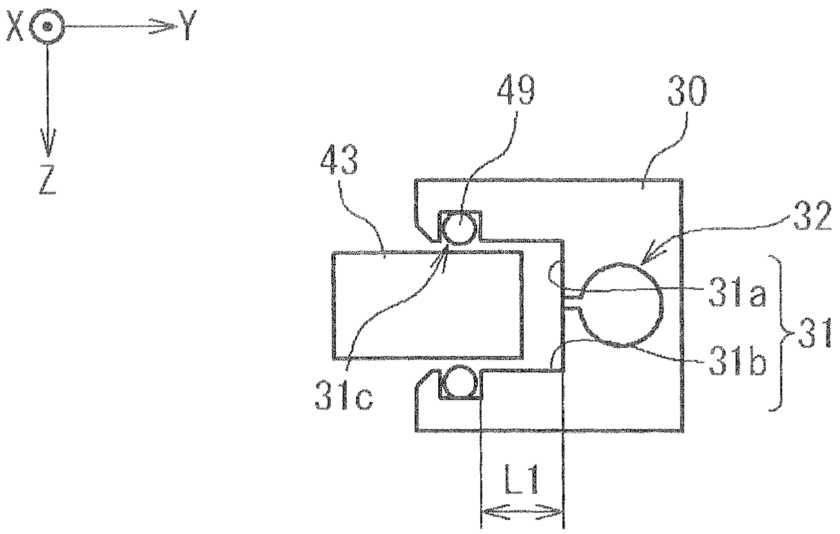


FIG. 14A

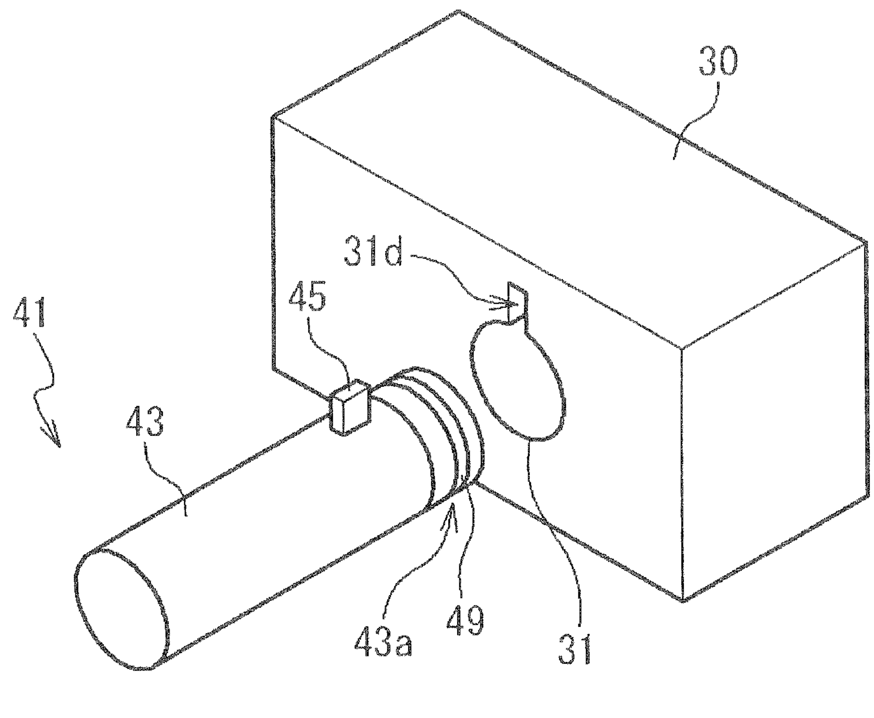

FIG. 14B

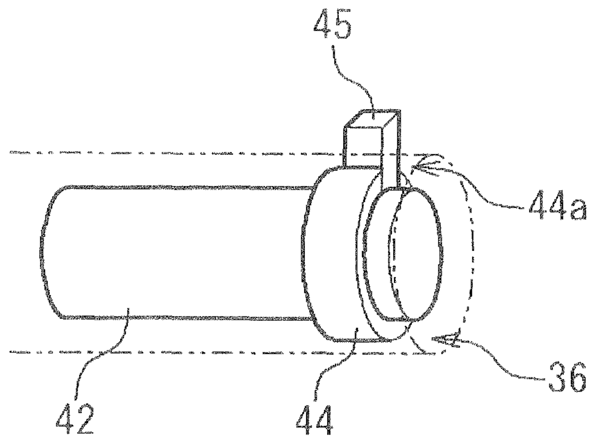


FIG. 15A

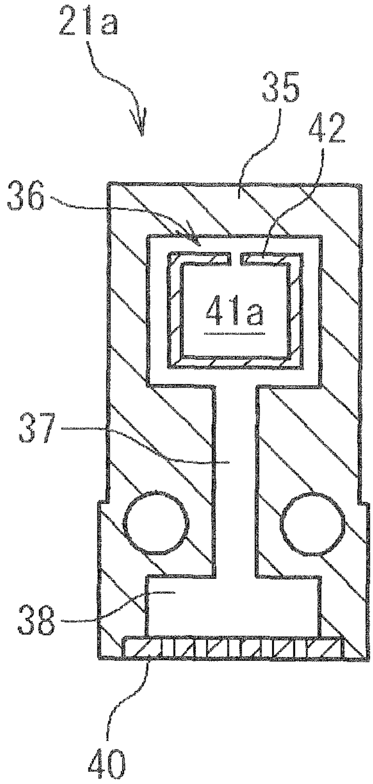

FIG. 15B

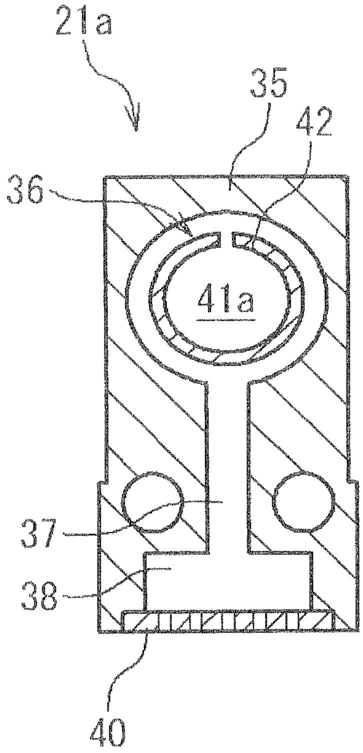


FIG. 15C

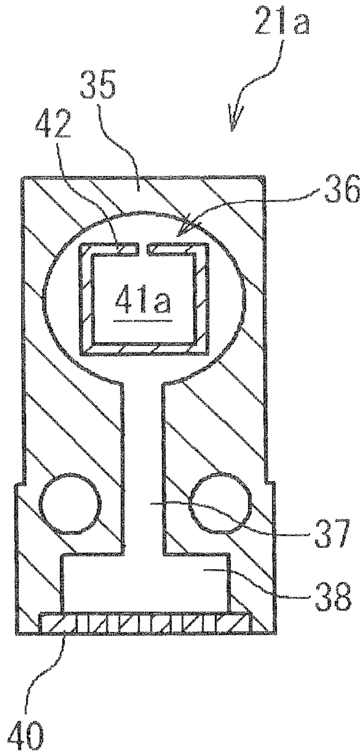

FIG. 16

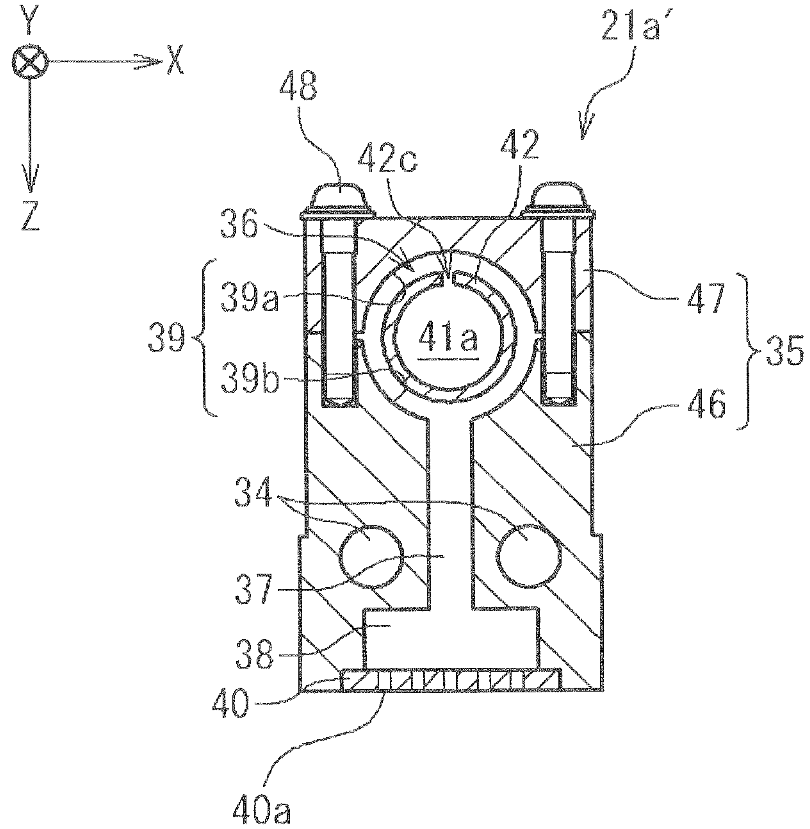

FIG. 17

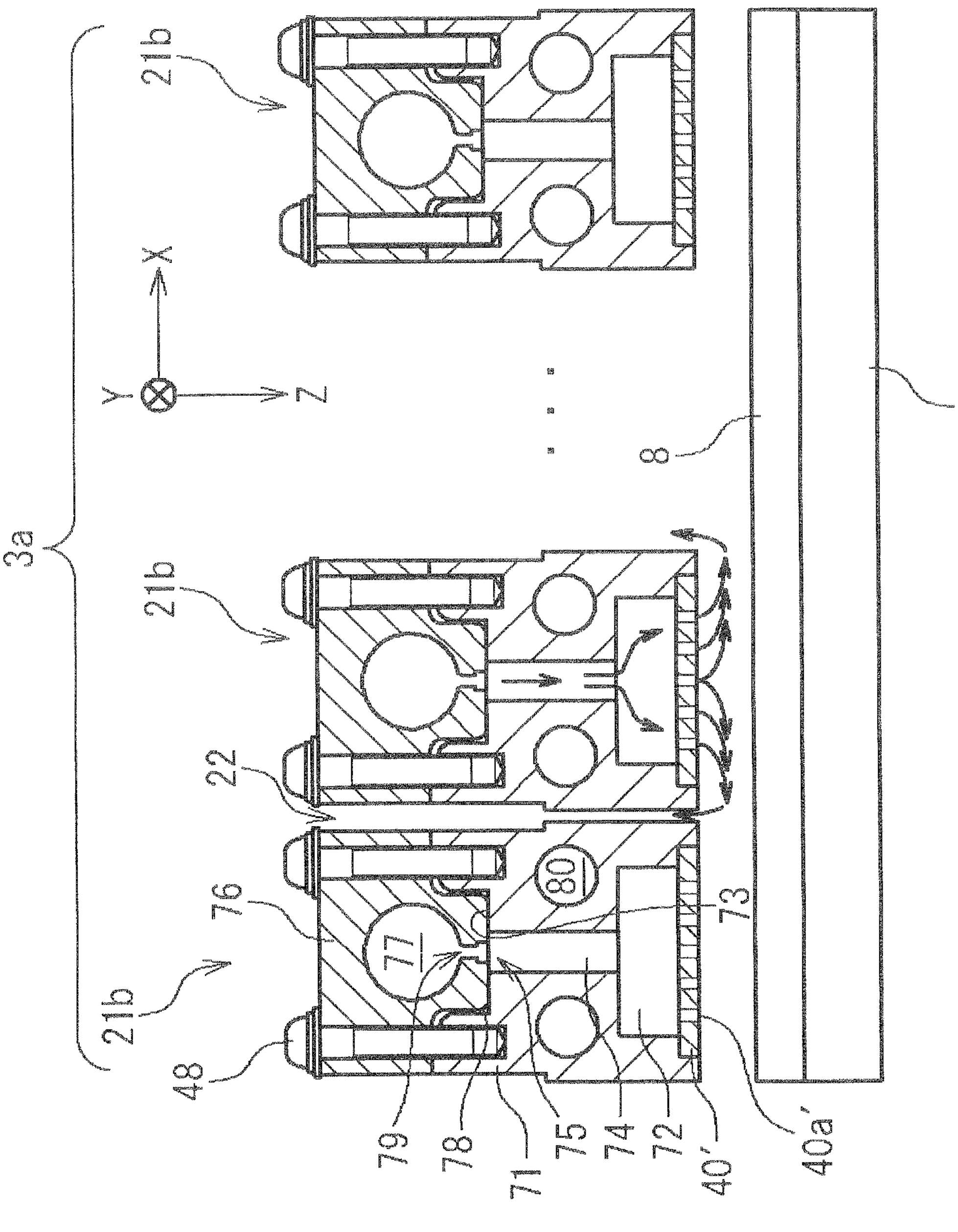

**INTERNATIONAL SEARCH REPORT**

International application No.
PCT/JP2007/066303

A. CLASSIFICATION OF SUBJECT MATTER
*H01L21/205*(2006.01)i, *C23C16/455*(2006.01)i, *C23C16/509*(2006.01)i

According to International Patent Classification (IPC) or to both national classification and IPC

B. FIELDS SEARCHED

Minimum documentation searched (classification system followed by classification symbols)
H01L21/205, C23C16/455, C23C16/509

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2007 |
| Kokai Jitsuyo Shinan Koho | 1971-2007 | Toroku Jitsuyo Shinan Koho | 1994-2007 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | JP 2005-26171 A (Matsushita Electric Works, Ltd.), 27 January, 2005 (27.01.05), All pages; all drawings (Family: none) | 1-18 |
| A | JP 2003-249492 A (Konica Corp.), 05 September, 2003 (05.09.03), All pages; all drawings (Family: none) | 1-18 |

☐ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 20 November, 2007 (20.11.07) | 27 November, 2007 (27.11.07) |
| Name and mailing address of the ISA/ Japanese Patent Office | Authorized officer |
| Facsimile No. | Telephone No. |

Form PCT/ISA/210 (second sheet) (April 2007)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2002322563 A
- JP 2005150317 A